# EUROPÄISCHE PATENTANMELDUNG

(11) **EP 4 842 145 A1**
(43) Veröffentlichungstag der Anmeldung: **18.11.2026**
(21) Anmeldenummer: 26178991.1
(22) Anmeldetag: 15.05.2026
(51) Int. Cl.: H05K 1/02, H01R 12/58

(54) **VERTIKALE STROMSCHIENEN FÜR LEITERPLATTEN**

(30) Priorität: 16.05.2025 DE 102025119118
(71) Anmelder: Würth Elektronik ICS GmbH & Co. KG, 74676 Niedernhall (DE)
(72) Erfinder: Meyer, Jakob, 74238 Krautheim-Neunstetten (DE); Lindenberger, Michael, 74653 Künzelsau (DE)
(74) Vertreter: Dilg, Haeusler, Schindelmann Patentanwaltsgesellschaft mbH

(57) **Zusammenfassung**

Die vorliegende Erfindung betrifft eine Leiterplattenanordnung (100), welche eine Leiterplatte (150), auf welcher zumindest ein erster elektrischer Anschlussbereich (151) ausgebildet ist, und eine Stromschienenanordnung mit einer ersten Stromschiene (110) zum Übertragen eines elektrischen Stroms, wobei die erste Stromschiene (110) zwei gegenüberliegende Hauptflächen aufweist, die an deren Umfang durch Schmalseiten (113) verbunden sind, aufweist. Die erste Stromschiene (110) weist einen ersten Steckabschnitt (111) und einen beabstandeten zweiten Steckabschnitt (112) auf, welche an einer oder an entsprechenden Schmalseiten (113) der ersten Stromschiene (110) ausgebildet sind, wobei der erste Steckabschnitt (111) zumindest einen ersten Einsteckpin (114) ausbildet und in dem ersten elektrischen Anschlussbereich (151) zumindest eine korrespondierende Einsteckbohrung (153) zur nicht lösbaren Befestigung des ersten Einsteckpins (114) vorgesehen ist. Der zweite Steckabschnitt (112) bildet zumindest einen zweiten Einsteckpin (115) aus, wobei eine korrespondierende zweite Einsteckbohrung (153) eines zweiten elektrischen Anschlussbereichs zur nicht lösbaren Befestigung des zweiten Einsteckpins (115) vorgesehen ist.

## Beschreibung

### Technisches Gebiet

Die vorliegende Erfindung bezieht sich auf eine Leiterplattenanordnung, die eine effiziente und zuverlässige elektrische Verbindung ermöglicht. Insbesondere bezieht sich die vorliegende Erfindung auf eine Stromschienenanordnung mit Steckabschnitten und Einsteckpins, die eine nicht lösbare Befestigung an entsprechenden Anschlussbereichen der Leiterplatte gewährleisten.

### Hintergrund der Erfindung

Auf dem Gebiet der Leiterplattenanordnungen ist es üblich, dass elektrische Komponenten und Verbindungen auf einer Leiterplatte montiert werden, um eine Vielzahl von elektronischen Funktionen zu ermöglichen. Leiterplatten dienen als Träger für elektronische Bauelemente und ermöglichen die elektrische Verbindung zwischen diesen Bauelementen durch Leiterbahnen. Diese Verbindungen sind entscheidend für die Funktionalität und Leistungsfähigkeit der elektronischen Geräte. Bekannte Systeme umfassen typischerweise eine Vielzahl von Leiterbahnen, die auf der Oberfläche oder innerhalb der Leiterplatte verlaufen, um elektrische Signale und Strom zu übertragen.

Leiterbahnen in Leiterplatten kommen häufig bei der Übertragung von hohen Strömen an thermische Grenzen und sind oftmals verlustbehaftet. Es besteht entsprechend ein Bedarf, hohe Ströme sicher und effizient zu übertragen, ohne die Integrität der Leiterplatte zu gefährden.

### Darstellung der Erfindung

Es ist eine Aufgabe der vorliegenden Erfindung, eine flexible Leiterplattenanordnung bereitzustellen, in welcher hohe Ströme robust und verlustarm übertragbar sind.

Dies Aufgabe wird mittels einer Leiterplattenanordnung, einer Stromschienenanordnung sowie einem Verfahren zum Herstellen einer Leiterplattenanordnung gemäß den unabhängigen Ansprüchen gelöst.

Gemäß einem ersten Aspekt der Erfindung wird eine Leiterplattenanordnung beschrieben, die eine Leiterplatte aufweist, auf welcher zumindest ein erster elektrischer Anschlussbereich ausgebildet ist. Die Leiterplattenanordnung weist eine Stromschienenanordnung mit einer ersten Stromschiene zum Übertragen eines elektrischen Stroms auf, wobei die erste Stromschiene zwei gegenüberliegende Hauptflächen aufweist, die an deren Umfang durch Schmalseiten verbunden sind, aufweist. Die erste Stromschiene weist einen ersten Steckabschnitt und einen beabstandeten zweiten Steckabschnitt auf, welche an einer oder an entsprechenden Schmalseiten der ersten Stromschiene ausgebildet sind. Der erste Steckabschnitt bildet zumindest einen ersten Einsteckpin aus. In dem ersten elektrischen Anschlussbereich ist zumindest eine korrespondierende Einsteckbohrung zur nicht lösbaren Befestigung des ersten Einsteckpins vorgesehen ist. Der zweite Steckabschnitt bildet zumindest einen zweiten Einsteckpin aus, wobei eine korrespondierende zweite Einsteckbohrung eines zweiten elektrischen Anschlussbereichs zur nicht lösbaren Befestigung des zweiten Einsteckpins vorgesehen ist.

Gemäß einem weiteren Aspekt der vorliegenden Erfindung wird eine Stromschienenanordnung für eine oben dargestellten Leiterplattenanordnung beschrieben.

Gemäß einem weiteren Aspekt der vorliegenden Erfindung wird ein Verfahren zum Herstellen der oben dargestellten Leiterplattenanordnung beschrieben.

Die Leiterplatte kann verschiedene Formen und Größen haben und ist in der Regel aus Materialien wie FR4, einem glasfaserverstärkten Epoxidharz, gefertigt. Die Leiterplatte (Leiterplatine) ist beispielsweise als Printed Circuit Board (PCB) ausgebildet und weist eine Vielzahl von Leiterbahnen und Koppelstellen für elektronische Bauteile oder elektrische Stecker auf. Die Leiterplatte weist an den entsprechenden elektrischen Anschlussbereichen insbesondere Einsteckbohrungen auf, die beispielsweise mit einer elektronischen Komponente oder mit einer Leiterbahnen der Leiterplatte elektrisch gekoppelt sind. Beispielsweise sind die Einsteckbohrungen an ihren Innenseiten mit leitenden Material beschichtet (z.B. mittels Kupfer). Entsprechend kann mittels Einstecken eines Einsteckpins die Stromschiene eine elektrische Verbindung zwischen der Leiterbahnen und dem Einsteckpin via den beschichteten Einsteckbohrungen bereitgestellt werden.

Eine Stromschiene ist ein leitendes Element, typischerweise aus Metall wie Kupfer, das dazu dient, elektrische Energie effizient zu übertragen und zu verteilen. Die erste Stromschiene weist zwei gegenüberliegende Hauptflächen auf, die durch Schmalseiten an deren Umfang verbunden sind. Die erste Stromschiene weist zwei gegenüberliegende Hauptflächen auf, die an deren Umfang durch Schmalseiten verbunden sind. Hauptflächen sind die größeren, gegenüberliegenden flachen Oberflächen der Stromschiene, während Schmalseiten die schmaleren, seitlichen Kanten sind, die die Hauptflächen miteinander verbinden. Stromschienen haben beispielsweise einen rechteckigen Umfang, können aber ebenso gebogene Schmalseiten aufweisen. Die Stromschiene erstreckt sich insbesondere in einer planaren Ebene. In einer beispielhaften Ausführungsform kann eine Stromschiene ebenfalls einen gekrümmten Verlauf aufweisen. Mit anderen Worten sind die Hauptflächen gekrümmt bzw. gebogen und verlaufen nicht in einer planaren Ebene. Die Stromschiene verteilt elektrischen Strom über eine größere Fläche, beispielsweise im Vergleich zu einer Leiterbahn der Leiterplatte. Die Verwendung von Materialien wie Kupfer-Zinn oder Kupfer-Zirkonium Legierungen für Stromschienen, die eine hohe spezifische Leitfähigkeit bieten, trägt zur Optimierung der elektrischen Leistung bei.

Die erste Stromschiene hat einen ersten Steckabschnitt und einen beabstandeten zweiten Steckabschnitt, welche an einer oder an entsprechenden Schmalseiten der ersten Stromschiene ausgebildet sind. Der erste Steckabschnitt bildet zumindest einen ersten Einsteckpin aus, und in dem ersten elektrischen Anschlussbereich der Leiterplatte ist zumindest die korrespondierende Einsteckbohrung zur nicht lösbaren Befestigung des ersten Einsteckpins vorgesehen. Eine nicht lösbare Verbindung ist eine Verbindung, die nach der Montage nicht ohne Zerstörung oder Beschädigung der beteiligten Komponenten getrennt werden kann. Beispiele für nicht lösbare Verbindungen sind Lötverbindungen, Klebeverbindungen oder Einpressverbindungen. Insbesondere bildet der Einsteckpin einen Einpresspin ein, welcher in eine Einsteckbohrungen derart eingepresst werden kann, dass ein reversibles Lösen verunmöglicht ist und insbesondere nicht zerstörungsfrei durchführbar ist.

In den Streckenabschnitten kann eine Stromschiene beispielsweise einen oder eine Vielzahl von Einsteckpins aufweisen, die in den zugehörigen ersten oder zweiten elektrischen Anschlussbereichen bzw. deren Einsteckbohrungen der Leiterplatte eingreifen können. Die Einsteckpins können in einem Steckabschnitt der Stromschiene beispielsweise einen mittleren Abstand von 0,5 - 5 mm, bevorzugt 1 - 2,5 mm, besonders bevorzugt 1,25 - 1,75 mm, insbesondere bevorzugt 1,5 mm aufweisen.

Da die Einsteckpins an der Schmalseite angeordnet sind und von einer Schmalseite entlang einer planaren Ebene, in welcher zumindest eine Hauptfläche verläuft, hervorragen, bilden die erfindungsgemäße Stromschienen insbesondere vertikale Stromschienen aus. Eine entsprechende Stromschiene ist, wenn die Einsteckpins in den entsprechenden Einsteckbohrungen befestigt sind, dabei entsprechend derart an einer Leiterplatte befestigt, dass die Hauptflächen orthogonal zu einer Oberfläche der Leiterplatte angeordnet sind. Mit anderen Worten ist eine Stromschienenebene (bzw. deren Normale), in welcher eine Hauptfläche der Stromschiene verläuft, orthogonal zu einer Leiterplattenebene (bzw. deren Normale), in welcher die Oberfläche der Leiterplatte verläuft. In einer beispielhaften Ausführungsform kann zwischen einer Oberfläche der Stromschiene und der Oberfläche der Leiterplatte ein Winkel zwischen 45° und 89° ausgebildet werden. Die Stromschienenanordnung kann in verschiedenen Anwendungen, wie der Board-to-Wire-Anbindung, der Mess-Schunt-Funktion und der Board-to-Board-Verbindung eingesetzt werden. Die unterschiedlichen Erstreckungslängen der Steckabschnitte bieten somit eine vielseitige und effiziente Lösung für die elektrische Verbindung und mechanische Stabilität von Leiterplatten in verschiedenen industriellen Anwendungen.

Mittels einer vertikalen Stromschiene sind deren Hauptflächen beabstandeten von einer Oberfläche der Leiterplatte. Somit kann eine zusätzlicher Installationsraum über der Oberfläche der Leiterplatte, ausgenutzt werden. Dadurch kann die Stromschiene größere Fläche aufweisen als beispielsweise die Leiterbahnen auf oder innerhalb der Leiterplatte. Dies führt dazu, dass die Stromdichte besser verteilt werden kann und zusätzlich thermische Energie über größere Flächen der Stromschiene abgegeben werden kann. Entsprechend können somit höhere Ströme effizienter übertragen werden. Die Stromschienen bilden somit einen zusätzlichen Leiterpfad für eine korrespondierende Leiterbahnen in der Leiterplatte.

Ein weiterer Vorteil ist die modulare Bauweise der Stromschienen, die eine hohe Flexibilität und Standardisierung ermöglicht, wodurch individuelle Stromschienen-Geometrien für verschiedene Anwendungen entfallen. Dies führt zu Kosteneinsparungen und einer einfacheren Montage.

Gemäß einer weiteren beispielhaften Ausführungsform ist der erste Anschlussbereich mit einem elektronischem Bauelement der Leiterplatte elektrisch gekoppelt. Dies bedeutet, dass die Leiterplatte nicht nur als mechanische Halterung für die Stromschiene dient, sondern auch eine aktive Rolle in der elektrischen Schaltung übernimmt. Die elektrische Kopplung zwischen dem Anschlussbereich und dem elektronischen Bauelement ermöglicht eine direkte und effiziente Übertragung von elektrischen Signalen und Strömen. Dies ist besonders vorteilhaft, da es die Gesamteffizienz der Leiterplattenanordnung erhöht und die Notwendigkeit zusätzlicher Verbindungen oder Komponenten reduziert. Die Integration eines elektronischen Bauelements in den ersten Anschlussbereich kann die Funktionalität der Leiterplatte erweitern und die Komplexität der Schaltung verringern. Durch die direkte elektrische Kopplung wird auch die Zuverlässigkeit der Verbindung verbessert, da weniger Übergangswiderstände und potenzielle Fehlerquellen vorhanden sind. Dies kann zu einer verbesserten Leistung und einer längeren Lebensdauer der gesamten Leiterplattenanordnung führen. Die Kombination der mechanischen Befestigung der Stromschiene mit der elektrischen Kopplung des Anschlussbereichs trägt zur Modularität und Flexibilität der Leiterplattenanordnung bei, da verschiedene elektronische Bauelemente leicht integriert und ausgetauscht werden können, ohne dass umfangreiche Änderungen an der Leiterplatte erforderlich sind. Dies kann die Entwicklungs- und Produktionskosten senken und die Anpassungsfähigkeit der Leiterplattenanordnung an unterschiedliche Anwendungen und Anforderungen erhöhen.

Gemäß einer weiteren beispielhaften Ausführungsform weist der erste Anschlussbereich ein Kopplungselement, insbesondere eine Steckerbuchse oder eine Gewindebuchse, zum Koppeln mit externen Strom- und/oder Signalelementen auf. Ein Kopplungselement wie eine Steckerbuchse ermöglicht eine einfache und sichere Verbindung zwischen der Leiterplattenanordnung und externen Komponenten, wodurch die Flexibilität und Einsatzmöglichkeiten der Leiterplattenanordnung erheblich erweitert werden. Eine Steckerbuchse bietet den Vorteil einer standardisierten Schnittstelle, die eine schnelle und zuverlässige Verbindung ermöglicht, was besonders in modularen Systemen von Bedeutung ist. Durch die Integration einer Gewindebuchse kann eine mechanisch stabile und dauerhafte Verbindung geschaffen werden, die auch bei Vibrationen oder mechanischen Belastungen zuverlässig bleibt. Dies ist besonders vorteilhaft in Anwendungen, bei denen eine hohe Modularität und Flexibilität erforderlich sind, wie beispielsweise in Power Distribution Units (PDUs), wo gezielte Unterstützung von Hotspots notwendig ist. Die Verwendung von vertikal einpressbaren Stromschienen in Kombination mit solchen Kopplungselementen kann die Wärmeableitung verbessern und die Stromdichte reduzieren, was zu einer höheren Effizienz und Zuverlässigkeit der gesamten Anordnung führt. Darüber hinaus ermöglicht die modulare Bauweise der Stromschienen eine einfache Anpassung an unterschiedliche Anforderungen und Geometrien, wodurch die Notwendigkeit individueller Lösungen entfällt und die Standardisierung erleichtert wird.

Gemäß einer weiteren beispielhaften Ausführungsform ist der zweite elektrische Anschlussbereich auf der Leiterplatte ausgebildet. Dadurch ist eine direkte und effiziente Integration der Stromschienenanordnung in die Leiterplatte möglich. Durch die Ausbildung des zweiten elektrischen Anschlussbereichs direkt auf der Leiterplatte wird eine stabile und zuverlässige Verbindung zwischen der Stromschiene und der Leiterplatte gewährleistet, was die mechanische Integrität der gesamten Anordnung verbessert. Dies ist besonders vorteilhaft, wenn es darum geht, Hotspots in Power Distribution Units (PDUs) gezielt zu unterstützen, da die Stromschienen eine erhöhte Fläche bieten, die zur Wärmeableitung beiträgt. Die vertikal einpressbaren Stromschienen ermöglichen eine effektive Reduktion der Stromdichte in der Leiterplatte, was wiederum die Lebensdauer und Leistungsfähigkeit der Leiterplatte erhöht. Die modulare Bauweise der Stromschienen erlaubt es, verschiedenste Leiterbahnzüge flexibel zu kombinieren.

Gemäß einer weiteren beispielhaften Ausführungsform ist der zweite elektrische Anschlussbereich beabstandet zu dem ersten elektrischen Anschlussbereich ausgebildet. Diese Konfiguration ermöglicht eine verbesserte mechanische Stabilität und elektrische Verbindung zwischen der Leiterplatte und der Stromschiene. Durch die beabstandete Anordnung der elektrischen Anschlussbereiche wird eine gleichmäßige Verteilung der mechanischen Belastung und der elektrischen Ströme erreicht. Die vertikal einpressbaren Stromschienen bieten eine gezielte Unterstützung von Hotspots in PDUs und ermöglichen durch ihren segmentierten Aufbau eine hohe Modularität und Standardisierung.

Gemäß einer weiteren beispielhaften Ausführungsform ist zwischen dem ersten elektrischen Anschlussbereich und dem zweiten elektrischen Anschlussbereich ein elektrischen Verbindungsbereich auf der Leiterplatte ausgebildet, welche den ersten elektrischen Anschlussbereich und den zweiten elektrischen Anschlussbereich miteinander elektrisch verbindet. Gemäß einer weiteren beispielhaften Ausführungsform bildet der elektrische Verbindungsbereich eine Leiterbahn auf der Oberfläche und/oder in der Leiterplatte aus, welche den ersten elektrischen Anschlussbereich mit dem zweiten elektrischen Anschlussbereich elektrisch koppelt. Diese Konfiguration ermöglicht eine effiziente und zuverlässige elektrische Verbindung zwischen verschiedenen Bereichen der Leiterplatte, wodurch die Stromschienenanordnung eine verbesserte elektrische Leistung und Stabilität bietet. Die Stromschiene oder mehrere Stromschienen können beispielsweise derart auf der Leiterplatte befestigt werden, dass die Stromschienen einen Verlauf der Leiterbahnen folgen und sozusagen deckungsgleich entlang den Leiterbahnen entlang der Oberfläche der Leiterplatte verlaufen.

Gemäß einer weiteren beispielhaften Ausführungsform weist die erste Stromschiene zwischen dem ersten Steckabschnitt und dem zweiten Steckabschnitt an einer Schmalseite Verbindungspins auf, wobei der elektrische Verbindungsbereich Einsteckbohrungen aufweist. Die Verbindungspins sind zur nicht lösbaren Verbindung mit dem korrespondierende Einsteckbohrungen im Verbindungsbereich ausgebildet.

Somit wird eine zuverlässige und dauerhafte Verbindung zwischen der Stromschiene und der Leiterplatte ermöglicht, wodurch die Stabilität und die elektrische Leitfähigkeit der gesamten Anordnung verbessert werden kann. Durch die zusätzliche mechanische Verbindung mittels der Verbindungspins wird zwischen der Stromschiene und der Leiterplatte die mechanische Stabilität der Leiterplattenanordnung erhöht, wodurch Vibrationen und mechanischen Belastungen besser standgehalten werden kann. Ferner wird die elektrische Verbindung durch die zusätzlichen Verbindungspins verbessert, was zu einem geringeren elektrischen Widerstand und einer effizienteren Stromübertragung führt. Dies ist besonders vorteilhaft in Anwendungen, bei denen hohe Ströme übertragen werden müssen, da die Stromschiene eine höhere Leitfähigkeit bietet und die Wärmeableitung verbessert wird.

Gemäß einer weiteren beispielhaften Ausführungsform sind die Verbindungspins und/oder die Einsteckpins einerseits und die Einsteckbohrungen andererseits derart ausgebildet, dass die Verbindungspins und/oder die Einsteckpins zur nicht lösbaren Verbindung in die Einsteckbohrungen einpressbar sind. Mittels einem Einpressmechanismus werden die Einsteckpins und/oder die Verbindungspins durch Einpressen in die Einsteckbohrungen mit einer festen und dauerhaften Verbindung an die Leiterplatte befestigt. Die Einpressbarkeit der Pins gewährleistet eine stabile und zuverlässige mechanische und elektrische Verbindung zwischen der Stromschiene und der Leiterplatte. Durch das Einpressen wird eine hohe Kontaktkraft erzeugt, die eine sichere elektrische Verbindung sicherstellt und mechanische Bewegungen oder Vibrationen widersteht. Dies ist besonders vorteilhaft in Anwendungen, bei denen die Leiterplattenanordnung hohen mechanischen Belastungen oder thermischen Zyklen ausgesetzt ist. Die nicht lösbare Verbindung verhindert das unbeabsichtigte Lösen der Pins und erhöht somit die Zuverlässigkeit der gesamten Leiterplattenanordnung. Ein weiterer Vorteil dieser Ausführungsform ist die Vereinfachung des Montageprozesses, da keine zusätzlichen Befestigungselemente wie Schrauben oder Klebstoffe erforderlich sind. Die Einpressverbindung ermöglicht auch eine kompaktere Bauweise der Leiterplattenanordnung, da die Pins direkt in die Bohrungen eingepresst werden können, ohne zusätzlichen Platz für Befestigungselemente zu benötigen. Somit kann insbesondere eine hohe Packungsdichte einer Vielzahl von vertikal Stromschienen auf der Leiterplatte ermöglicht werden.

Gemäß einer weiteren beispielhaften Ausführungsform sind der zweite elektrische Anschlussbereich und der erste elektrische Anschlussbereich mittels der ersten Stromschiene elektrisch verbunden und die erste Stromschiene einen Zwischenbereich zwischen dem ersten elektrischen Anschlussbereich und dem zweiten elektrischen Anschlussbereich überbrückt. Gemäß einer weiteren beispielhaften Ausführungsform weist der Zwischenbereich eine größere Querschnittsfläche, insbesondere eine mehr als 4-fach, insbesondere mehr als 10-fach größere Querschnittsfläche als eine elektrisch leitende Querschnittsfläche des Verbindungsbereichs der Leiterplatte aufweist. Die größere Querschnittsfläche des Zwischenbereichs bietet den Vorteil einer erhöhten mechanischen Stabilität und einer besseren Verteilung der elektrischen Last, wodurch Hotspots auf der Leiterplatte gezielt unterstützt werden können. Durch die Erhöhung der Fläche des Zwischenbereichs wird die Wärmeableitung verbessert, was zu einer niedrigeren Betriebstemperatur der Leiterplatte führt und die Lebensdauer der elektronischen Komponenten verlängert. Zudem wird durch die Reduktion des Widerstands die Effizienz der Stromübertragung erhöht, was zu einer geringeren Verlustleistung und einer höheren Energieeffizienz führt. Durch die gezielte Unterstützung von Hotspots können Kosteneinsparungen bei den Leiterplatten von bis zu 40% erreicht werden, da es nicht mehr notwendig ist, den gesamten Kupferanteil durch zusätzliche Lagen der Leiterplatte zu erhöhen.

Gemäß einer weiteren beispielhaften Ausführungsform weist der Zwischenbereich auf der Oberfläche Kühlstrukturen, insbesondere Kühlrippen, zur Erhöhung der passiven Kühlwirkung auf. Diese Kühlstrukturen sind im Zwischenbereich der Stromschiene angeordnet und dienen der effektiven Wärmeableitung, die durch die Vergrößerung der Oberfläche der Stromschiene ermöglicht wird. Die Kühlrippen tragen dazu bei, die Temperatur der Stromschiene zu senken, indem sie die Wärme effizienter an die Umgebung abgeben. Dies ist besonders vorteilhaft in Anwendungen, bei denen Hotspots auf der Leiterplatte gezielt unterstützt werden müssen, wie in Power Distribution Units (PDUs). Die Kühlstrukturen verbessern nicht nur die Wärmeableitung, sondern tragen auch zur Reduzierung der Stromdichte in der Leiterplatte bei, was eine bessere Ausnutzung der Einsteckpins ermöglicht und die maximale Stromdichte verringert.

Gemäß einer weiteren beispielhaften Ausführungsform weist der Zwischenbereich einen Kühlkanal auf, welcher zur Aufnahme eines Kühlmediums ausgebildet ist. Dieser Kühlkanal dient der effizienten Wärmeableitung und verbessert die thermische Leistung der Leiterplattenanordnung. Der Kühlkanal ermöglicht die Zirkulation eines Kühlmediums, wie beispielsweise Wasser oder ein anderes geeignetes Kühlmittel, durch den Zwischenbereich der Stromschiene. Dadurch wird die Wärme, die durch den elektrischen Stromfluss erzeugt wird, effektiv abgeführt und die Betriebstemperatur der Leiterplatte gesenkt. Die Kühlkanäle können direkt in die bestehenden Fertigungslinien integriert werden, ohne zusätzliche Arbeitsschritte zu erfordern, was die Produktionsprozesse vereinfacht und beschleunigt.

Gemäß einer weiteren beispielhaften Ausführungsform ist in dem Zwischenbereich die Leiterplatte eine weitere Leiterbahn auf der Oberfläche und/oder in der Leiterplatte ausgebildet, welche die Stromschiene passiert. Die Stromschiene überbrückt somit mit ihrem Zwischenbereich eine weitere Leiterbahnen, sodass mit der Stromschiene eine Strombrücke bzw. Signalbrücke über eine weitere Leiterbahnen der Leiterplatte geschaffen werden kann. Diese weitere Leiterbahn ermöglicht eine zusätzliche elektrische Verbindung oder Signalübertragung, die die Funktionalität der Leiterplattenanordnung erweitert. Durch die Integration einer weiteren Leiterbahn im Zwischenbereich wird die Modularität der Leiterplattenanordnung erhöht, was eine flexible Anpassung an unterschiedliche Anforderungen und Anwendungen ermöglicht. Die weitere Leiterbahn kann sowohl auf der Oberfläche der Leiterplatte als auch innerhalb der Leiterplatte ausgebildet sein, wodurch eine optimale Nutzung des verfügbaren Platzes und eine effiziente Verteilung der elektrischen Signale erreicht wird.

Gemäß einer weiteren beispielhaften Ausführungsform weist die Stromschienenanordnung eine zweite Stromschiene zum Übertragen eines elektrischen Stroms auf, wobei die zweite Stromschiene einen dritten Steckabschnitt und einen beabstandeten vierten Steckabschnitt aufweist, welche an einer oder an entsprechenden Schmalseiten der zweiten Stromschiene ausgebildet sind. Der dritte Steckabschnitt bildet zumindest einen dritten Einsteckpin aus, wobei in dem ersten elektrischen Anschlussbereich zumindest eine korrespondierende Einsteckbohrung zur nicht lösbaren Befestigung des dritten Einsteckpins vorgesehen ist. Der vierte Steckabschnitt der zweiten Stromschiene bildet zumindest einen vierten Einsteckpin aus, wobei in einer korrespondierende vierten Einsteckbohrung des zweiten elektrischen Anschlussbereichs zur nicht lösbaren Befestigung des vierten Einsteckpins vorgesehen ist. Die zweite Stromschiene kann entsprechend der ersten Stromschiene ausgebildet sein. Die Verwendung einer zweiten Stromschiene bietet den Vorteil einer erhöhten Modularität und Flexibilität in der Gestaltung der Leiterplattenanordnung. Durch die segmentierte Bauweise der Stromschienen können verschiedenste Leiterbahnzüge flexibel kombiniert werden. Darüber hinaus trägt die zweite Stromschiene zur Reduktion des elektrischen Widerstands und zur Verbesserung der Wärmeableitung bei, indem die Fläche für die Wärmeabgabe vergrößert wird. Die nicht lösbare Befestigung der Einsteckpins der zweiten Stromschiene in den korrespondierenden Einsteckbohrungen gewährleistet eine dauerhafte und sichere Verbindung, die mechanischen Belastungen standhält und die Zuverlässigkeit der elektrischen Kontakte erhöht. Die Integration der zweiten Stromschiene in die Leiterplattenanordnung ermöglicht zudem eine einfachere und effizientere Montage, da keine zusätzlichen Komponenten oder Arbeitsschritte erforderlich sind.

Gemäß einer weiteren beispielhaften Ausführungsform ist die zweite Stromschiene parallel zu der ersten Stromschiene angeordnet. Insbesondere kann die zweite Stromschiene beispielsweise parallel zu ersten Stromschiene verlaufen und ebenfalls insbesondere als vertikale Stromschiene ausgebildet sein. Die parallele Anordnung der Stromschienen bietet die Möglichkeit, komplexe Leiterbahnzüge der Leiterplatte einfach und effizient nachzubilden, und somit die Stromdichte in den nachgebildeten Leiterbahnenzügen zu reduzieren.

Gemäß einer weiteren beispielhaften Ausführungsform weist zumindest die erste Stromschiene eine erste Teilschiene und eine zweite Teilschiene auf, wobei die erste Teilschiene den ersten Steckabschnitt aufweist und die zweite Teilschiene den zweiten Steckabschnitt aufweist. Die erste Teilschiene weist einen ersten Verbindungsabschnitt mit ersten Verbindungspins auf, die zur nicht lösbaren Verbindung mit korrespondierende Einsteckbohrungen im Verbindungsbereich ausgebildet sind, wobei die zweite Teilschiene einen zweiten Verbindungsabschnitt mit zweiten Verbindungspins aufweist, die zur nicht lösbaren Verbindung mit korrespondierende Einsteckbohrungen im Verbindungsbereich ausgebildet sind. Die erste Stromschiene kann zudem aus drei oder mehr Teilschienen ausgebildet sein.

Die erste Stromschiene wird somit strukturell in eine erste Teilschiene und in eine zweite Teilschiene getrennt. Entsprechend kann die erste Teilschiene und die zweite Teilschiene entlang einer linearen Richtung hintereinander angeordnet werden oder in einem Winkel zueinander. Gemäß einer beispielhaften Ausführungsform sind die erste Teilschiene und die zweite Teilschiene beabstandet zueinander angeordnet. An den zugewandten Kante der ersten Teilschiene zu der zweiten Teilschiene kann ein Abstand (Luftspalt) bestehen oder alternativ ein Berührkontakt bestehen, sodass über die zugewandten Kanten ein Stromfluss bereitgestellt werden kann. Bei einer Beanstandungen der ersten Teilschiene zu der zweiten Teilschiene kann eine elektrische Verbindung zwischen den Teilschienen über die Leiterplatte ermöglicht werden. Beispielsweise kann die erste Teilschiene den ersten Verbindungsabschnitt mit ersten Verbindungspins aufweisen, die eine elektrischen Kontakt in korrespondierenden Einsteckbohrungen der Leiterplatte im Verbindungsbereich ausbilden. Entsprechend kann die zweite Teilschiene den zweiten Kopplungsabschnitt mit den ersten Verbindungspins aufweisen, um eine elektrisch leitende Verbindung mit korrespondierende Einsteckbohrungen der Leiterplatte im Verbindungsbereiche ausbilden. Über den Verbindungsbereiche sind die entsprechenden ersten und zweiten Verbindungspins und entsprechend die erste Teilschiene und die zweite Teilschiene elektrisch leitende verbunden.

Durch die Unterteilung der Stromschiene in zwei Teilschienen wird eine erhöhte Modularität und Flexibilität bei der Gestaltung und Montage der Leiterplattenanordnung ermöglicht. Dies erleichtert die Anpassung an verschiedene Leiterbahnzüge und komplexe Verläufe, ohne dass individuelle Stromschienen-Geometrien für jeden Kunden entwickelt werden müssen. Durch die räumliche Trennung der Teilschienen wird die Fläche der Leiterplatte optimal genutzt, was zu einer Reduktion der Stromdichte führt und die thermische Belastung der Leiterplatte verringert. Die segmentierte Bauweise der Stromschienen trägt zur Modularität der Leiterplattenanordnung bei, was eine flexible Anpassung an unterschiedliche Anforderungen ermöglicht und die Notwendigkeit individueller Stromschienen-Geometrien für verschiedene Kunden eliminiert. Die beabstandete Anordnung der Teilschienen ermöglicht zudem eine einfache Integration in bestehende Fertigungslinien, da keine zusätzlichen Arbeitsschritte erforderlich sind.

Gemäß einer beispielhaften Ausführungsform erstreckt sich die erste Teilschiene von dem ersten Einsteckabschnitt mit einer ersten Erstreckungslänge entlang einer ersten Erstreckungsrichtung zu dem ersten Verbindungsabschnitt und die zweite Teilschiene erstreckt sich von dem zweiten Einsteckabschnitt mit einer zweiten Erstreckungslänge entlang einer zweiten Erstreckungsrichtung zu dem zweiten Verbindungsabschnitt. Gemäß einer beispielhaften Ausführungsform ist die erste Erstreckungslänge gleich der zweiten Entsprechungslänge. Alternativ, in einer weiteren beispielhaften Ausführungsform unterscheidet sich die erste Erstreckungslänge von der zweiten Erstreckungslänge.

Die erste Erstreckungslänge und die zweite Erstreckungslänge beziehen sich auf die Länge der Stromschiene entlang ihrer Hauptachse. Die Erstreckungslängen beziehen sich insbesondere auf die Abmessungen der Steckabschnitte entlang der Schmalseiten der Stromschiene. Durch die unterschiedliche Länge der Erstreckungsabschnitte kann die Stromschiene flexibel in verschiedenen Bereichen der Leiterplatte eingesetzt werden, um eine optimale elektrische Verbindung und Stromübertragung zu gewährleisten.

Diese Flexibilität ist besonders vorteilhaft in Anwendungen, bei denen unterschiedliche elektrische Komponenten oder Bereiche der Leiterplatte unterschiedliche Anforderungen an die Stromversorgung haben. Die Verwendung von Stromschienen mit variabler Länge ermöglicht es, die Leiterplattenanordnung effizienter zu gestalten. Durch die gezielte Platzierung der Stromschiene mit unterschiedlichen Längen können Hotspots auf der Leiterplatte effektiv unterstützt und die maximale Temperatur reduziert werden.

Gemäß einer beispielhaften Ausführungsform sind die erste Erstreckungsrichtung und die zweite Erstreckungsrichtung parallel zueinander sind. In einer alternativen weiteren beispielhaften Ausführungsform weisen die erste Erstreckungsrichtung und die zweite Erstreckungsrichtung einen Winkel zueinander aufweisen, wobei der Winkel beispielsweise zwischen 45° und 125°, insbesondere 90°, beträgt.

Gemäß einer weiteren beispielhaften Ausführungsform weist zumindest die zweite Stromschiene eine dritte Teilschiene und eine vierte Teilschiene auf, wobei die dritte Teilschiene den dritten Steckabschnitt aufweist und die vierte Teilschiene den vierten Steckabschnitt aufweist, wobei die dritte Teilschiene einen dritten Verbindungsabschnitt mit dritten Verbindungspins aufweist, die zur nicht lösbaren Verbindung mit korrespondierende Einsteckbohrungen im Verbindungsbereich ausgebildet sind. Die vierte Teilschiene weist einen vierten Verbindungsabschnitt mit vierten Verbindungspins auf, die zur nicht lösbaren Verbindung mit korrespondierende Einsteckbohrungen im zweiten Anschlussbereich ausgebildet sind. Die zweite Stromschiene kann zudem aus drei oder mehr Teilschienen ausgebildet sein.

Die Teilschienen sind so konzipiert, dass sie jeweils spezifische Steckabschnitte und Verbindungsabschnitte aufweisen, die eine nicht lösbare Verbindung mit der Leiterplatte ermöglichen. Die dritte Teilschiene ist mit einem dritten Steckabschnitt ausgestattet, der dritte Verbindungspins enthält, welche in korrespondierende Einsteckbohrungen im Verbindungsbereich der Leiterplatte eingeführt werden. Analog dazu ist die vierte Teilschiene mit einem vierten Steckabschnitt versehen, der vierte Verbindungspins enthält, die in korrespondierende Einsteckbohrungen im zweiten Anschlussbereich der Leiterplatte eingeführt werden. Die Unterteilung der Stromschienen in Teilschienen ermöglicht eine erhöhte Modularität und Flexibilität bei der Gestaltung der Leiterplattenanordnung.

Gemäß einer weiteren beispielhaften Ausführungsform erstreckt sich die dritte Teilschiene von dem dritten Einsteckabschnitt mit einer dritten Erstreckungslänge entlang einer dritten Erstreckungsrichtung zu dem dritten Verbindungsabschnitt erstreckt und die vierte Teilschiene von dem vierten Einsteckabschnitt mit einer vierten Erstreckungslänge entlang einer vierten Erstreckungsrichtung zu dem vierten Verbindungsabschnitt.

Gemäß einer weiteren beispielhaften Ausführungsform unterscheiden sich zumindest eine der ersten und zweiten Erstreckungslängen von zumindest einer der dritten und vierten Erstreckungslängen unterscheidet.

Die Erstreckungslängen beziehen sich auf die Abmessungen der Teilschienen entlang der Schmalseiten der Stromschiene. Die Variation in den Erstreckungslängen ermöglicht eine flexible Anpassung der Stromschienen an die spezifischen Anforderungen der Leiterplatte und ihrer elektrischen Anschlussbereiche. Durch die unterschiedlichen Erstreckungslängen können die Stromschienen so gestaltet werden, dass sie optimal auf die räumlichen Gegebenheiten und die elektrischen Anforderungen der Leiterplatte abgestimmt sind. Insbesondere, wenn die erste Stromschiene und die zweite Stromschiene abschnittsweise einem parallelen Verlauf ausbilden, so kann durch die Ausgestaltung der unterschiedlichen Erstreckungslänge der Teilschienen umgesetzt werden, dass die Trennfugen zwischen den ersten und zweiten Teilschiene der ersten Stromschiene und den vierten und fünften Teilschiene der zweiten Stromschiene an unterschiedlichen Stellen sind bzw. nicht an derselben Stelle entlang der Gesamtlänge der ersten Teilschiene und der zweiten Teilschiene. Somit können Temperaturspitzen an den Übergangsbereichen der Teilschiene in der Leiterplatte reduziert werden, da der Stromfluss zweier Teilschiene durch die Leiterplatte an unterschiedlichen Positionen der Leiterplatte verortet ist.

Gemäß einer beispielhaften Ausführungsform weist die Leiterplattenanordnung ferner ein Anschlusselement auf, welches zum Ausbilden einer elektrischen Verbindung einer externen elektrischen Vorrichtung mit zumindest der ersten Stromschiene ausgebildet ist. Das Anschlusselement ermöglicht eine direkte und zuverlässige Verbindung direkt an die entsprechende Stromschiene, wodurch die Funktionalität der Leiterplattenanordnung erweitert wird. Für die Ankopplung einer externen elektrischen Vorrichtung an die leitenden Struktur der Leiterplatte ist es somit nicht notwendig, über ein Koppelelement, beispielsweise eine Steckerbuchse, an der Leiterplatte selbst eine Kopplung zu generieren, sondern das Anschlusselement kann entlang der Stromschiene eine elektrische Kopplung umsetzen und die übertragenen elektrischen Signale über die Stromschiene an eine entsprechende Komponente in der Leiterplatte übertragen. Das Anschlusselement kann beispielsweise durch unterschiedliche Steckverbinder, Klemmen oder andere Verbindungselemente realisiert werden. Ein Vorteil dieser Ausführungsform ist die erhöhte Modularität und Anpassungsfähigkeit der Leiterplattenanordnung, da sie nun in der Lage ist, externe Komponenten ohne zusätzliche komplexe Verkabelung oder Montageprozesse zu integrieren. Ein weiterer Vorteil ist die verbesserte Wärmeableitung durch die erhöhte Fläche der Stromschiene, die durch das Anschlusselement nicht beeinträchtigt wird. Die Kombination aus vertikal einpressbaren Stromschienen und dem Anschlusselement ermöglicht eine gezielte Unterstützung von Hotspots in PDUs und eine hohe Modularität, die eine Standardisierung und Kosteneffizienz fördert. Die Leiterplattenanordnung kann somit in einem breiten Einsatzgebiet verwendet werden, von der Verbindung von Powerelementen bis hin zu komplexen Board-to-Board-Verbindungen, was die Vielseitigkeit und Anwendungsmöglichkeiten erheblich erweitert.

Gemäß einer weiteren beispielhaften Ausführungsform weist das Anschlusselement eine Klemmeinrichtung auf, mittels welcher das Anschlusselement an zumindest die erste Stromschiene angeklemmt werden kann. Die Klemmeinrichtung stellt eine mechanische Verbindung dar, die eine zuverlässige elektrische Kontaktierung gewährleistet, ohne dass zusätzliche Werkzeuge oder komplexe Befestigungsmethoden erforderlich sind. Durch die Verwendung einer Klemmeinrichtung wird die Flexibilität und Modularität der Leiterplattenanordnung erhöht, da das Anschlusselement bei Bedarf leicht entfernt und wieder angebracht werden kann. Die Klemmrichtung kann beispielsweise zwei gegenüberliegende Klemmelemente (Klemmbacken) aufweisen, wobei zwischen den Klemmelementen die Stromschiene angeklemmt werden kann. Die Klemmelemente können beispielsweise elastisch miteinander verbunden werden oder zueinander verstellbar und fixiert werden, sodass ein Spalt zwischen den Klemmelementen einstellbar ist. Die Klemmelemente können selbst flächige Bereiche ausbilden, um einen Flächenkontakt mit der Stromschiene herzustellen. Somit kann eine effiziente leitende Kontaktverbindung hergestellt werden.

Gemäß einer weiteren beispielhaften Ausführungsform bildet das Anschlusselement einen Mess-Shunt (Messnebenschluss) aus. Ein Mess-Shunt ist eine spezielle Komponente, die zur Messung elektrischer Ströme verwendet wird, indem sie einen kleinen, bekannten Widerstand in den Stromkreis einfügt. Der Spannungsabfall über diesem Widerstand wird gemessen, um den durchfließenden Strom zu berechnen. Die einfache Integration eines Mess-Shunts in die Leiterplattenanordnung über die Kopplung an der Stromschiene bietet mehrere Vorteile. Einerseits ermöglicht diese Kopplung eine präzise Strommessung direkt auf der Leiterplatte, was die Notwendigkeit externer Messgeräte reduziert und die Komplexität der Schaltungsanordnung verringert. Ferner trägt der Mess-Shunt zur Verbesserung der Modularität der Leiterplattenanordnung bei, da er als ein standardisiertes Element in verschiedenen Konfigurationen eingesetzt werden kann. Dies unterstützt die flexible Anpassung der Leiterplattenanordnung an unterschiedliche Anforderungen und Anwendungen, ohne dass umfangreiche Änderungen an der grundlegenden Struktur erforderlich sind. Ferner kann die Verwendung eines Mess-Shunts zur Optimierung der Wärmeableitung beitragen, indem er als zusätzlicher Kühlkörper fungiert, der die Wärme von den Stromschienen ableitet. Die vertikal einpressbaren Stromschienen unterstützen somit die effiziente Verbindung und Integration des Mess-Shunts, indem sie eine robuste mechanische und elektrische Verbindung zwischen den verschiedenen Komponenten der Leiterplattenanordnung gewährleisten.

Gemäß einer weiteren beispielhaften Ausführungsform ist das Anschlusselement mit einem drahtgebunden Stromleiter gekoppelt, sodass mittels des Anschlusselements eine elektrische Verbindung zwischen dem Stromleiter und der ersten Stromschiene bereitstellbar ist. Das Anschlusselement ermöglicht eine effektive und zuverlässige Verbindung zwischen dem externen Stromleiter und der Stromschiene, wodurch der elektrische Strom effizient übertragen werden kann. Durch die Kopplung des Anschlusselements mit dem drahtgebundenen Stromleiter wird die Integration von externen Stromquellen bzw. externer elektronischer Bauteile erleichtert, was insbesondere bei komplexen elektrischen Systemen von Vorteil ist.

Gemäß einer weiteren beispielhaften Ausführungsform weist die Leiterplattenanordnung eine weitere Leiterplatte auf, wobei der zweite elektrische Anschlussbereich auf der weiteren Leiterplatte ausgebildet ist. Diese Konfiguration ermöglicht eine erweiterte Flexibilität und Modularität bei der Gestaltung von Leiterplattenanordnungen. Durch die Verwendung einer zusätzlichen Leiterplatte wird die Möglichkeit geschaffen, komplexe elektrische Schaltungen zu realisieren, die eine Vielzahl von elektrischen Komponenten und Verbindungen umfassen. Die weitere Leiterplatte kann als eine Art Erweiterungsmodul fungieren, das zusätzliche Funktionen oder Kapazitäten bereitstellt, ohne die Hauptleiterplatte übermäßig zu belasten. Dies ist besonders vorteilhaft in Anwendungen, bei denen eine hohe Dichte an elektrischen Verbindungen erforderlich ist oder bei denen unterschiedliche elektrische Schaltungen in einem kompakten Format integriert werden müssen. Die Verbindung zwischen der Hauptleiterplatte und der weiteren Leiterplatte erfolgt über den zweiten elektrischen Anschlussbereich, der auf der zusätzlichen Leiterplatte ausgebildet ist. Diese Art der Verbindung ermöglicht einen effizienten Signalaustausch und die Übertragung hoher Ströme zwischen den Leiterplatten, was die Leistungsfähigkeit des gesamten Systems erhöht. Die modulare Bauweise der Stromschienen ermöglicht es, verschiedenste Leiterbahnzüge zweier getrennter Leiterplatten flexibel mit den Stromschienen zu kombinieren.

Gemäß einer weiteren beispielhaften Ausführungsform sind der erste Steckabschnitt und der zweite Steckabschnitt auf derselben Schmalseite der ersten Stromschiene angeordnet, wobei die Leiterplatte und die weitere Leiterplatte nebeneinander (entlang einer gemeinsamen planaren Ebene) angeordnet sind und die erste Stromschiene an dem ersten elektrischen Anschlussbereich der Leiterplatte und dem zweiten elektrischen Anschlussbereich gekoppelt ist. Dies ermöglicht eine effiziente und platzsparende Verbindung zwischen den Leiterplatten, da die Stromschiene vertikal eingepresst wird und somit eine stabile und zuverlässige elektrische Verbindung gewährleistet. Durch die vertikale Einpressung der Stromschiene werden Hotspots in Power Distribution Units (PDUs) gezielt unterstützt, was zu einer verbesserten Wärmeableitung und einer Reduktion des elektrischen Widerstands führt. Die vertikal einpressbare Stromschiene ermöglicht somit eine effiziente Board-to-Board-Verbindung, die hohe Ströme übertragen kann und als Signalbrücke fungiert, wodurch ein effizienter Signalaustausch zwischen den Leiterplatten ermöglicht wird. Die einfache Montage der Stromschiene und die breite Einsatzmöglichkeit in verschiedenen Anwendungen, wie zum Beispiel in modularen Hochspannungsboxen, tragen zur Effizienz der erfindungsgemäßen Leiterplattenanordnung bei. Die verschiedenen Geometrien der Stromschiene, wie gerade, gewinkelt oder mit unterschiedlichen Konturen, bieten zusätzliche Flexibilität bei der Gestaltung der Leiterplattenanordnung und insbesondere der Anordnung verschiedener Leiterplatten, die mit den Stromschienen verbunden sind.

Gemäß einer beispielhaften Ausführungsform weist die erste Stromschiene eine erste Schmalseite und eine, an die erste Schmalseite angrenzende zweite Schmalseite auf, wobei die erste Schmalseite und die zweite Schmalseite einen Winkel zueinander aufweisen, wobei der Winkel insbesondere 90° beträgt. Der erste Steckabschnitt ist an der ersten Schmalseite und der zweite Steckabschnitt ist an der zweiten Schmalseite ausgebildet ist, sodass die Leiterplatte und die weitere Leiterplatte in einem Winkel zueinander anordbar sind. Somit können die Leiterplatten in verschiedenen Winkel zueinander angeordnet werden, sodass eine flexible und platzsparende Anordnung der Leiterplatten möglich ist. Durch die Anordnung der Leiterplatten in einem Winkel zueinander wird eine effiziente Nutzung des verfügbaren Platzes ermöglicht und gleichzeitig die Möglichkeit geschaffen, komplexe elektrische Verbindungen zu realisieren. Die vertikale Einpressbarkeit der Stromschienen unterstützt die Modularität und Standardisierung der Leiterplattenanordnung, wodurch eine kostengünstige und wirtschaftliche Lösung für die Verbindung von Leiterplatten geschaffen wird.

Gemäß einer weiteren beispielhaften Ausführungsform weist die erste Stromschiene eine erste Schmalseite und eine, bezüglich der Hauptflächen gegenüberliegende zweite Schmalseite auf. Die erste Schmalseite und die zweite Schmalseite sind parallel und beabstandet zueinander ausgebildet. Der erste Steckabschnitt ist an der ersten Schmalseite und der zweite Steckabschnitt ist an der zweiten Schmalseite ausgebildet ist, sodass die Leiterplatte und die weitere Leiterplatte parallel und beabstandet zueinander anordbar. Durch die parallele Anordnung wird eine optimierte Wärmeableitung erzielt, da die erhöhte Fläche der Stromschienen eine verbesserte Kühlung durch Zwangskonvektion ermöglicht. Darüber hinaus wird durch die modulare Bauweise der Stromschienen eine hohe Flexibilität bei der Gestaltung der Leiterbahnzüge erreicht,

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind. Insbesondere sind einige Ausführungsformen der Erfindung mit Vorrichtungsansprüchen und andere Ausführungsformen der Erfindung mit Verfahrensansprüchen beschrieben. Dem Fachmann wird jedoch bei der Lektüre dieser Anmeldung sofort klar werden, dass, sofern nicht explizit anders angegeben, zusätzlich zu einer Kombination von Merkmalen, die zu einem Typ von Erfindungsgegenstand gehören, auch eine beliebige Kombination von Merkmalen möglich ist, die zu unterschiedlichen Typen von Erfindungsgegenständen gehören.

### Kurze Beschreibung der Zeichnungen

Im Folgenden werden zur weiteren Erläuterung und zum besseren Verständnis der vorliegenden Erfindung Ausführungsbeispiele unter Bezugnahme auf die beigefügten Zeichnungen näher beschrieben. Es zeigen:
Figur 1 zeigt eine schematische Darstellung einer Ausführungsform einer Leiterplattenanordnung mit einer Stromschiene und zwei elektrischen Anschlussbereichen gemäß einer beispielhaften Ausführungsform der vorliegenden Erfindung.
Figur 2 zeigt eine Ausführungsform eines Kopplungselements auf einer Leiterplatte gemäß einer beispielhaften Ausführungsform der vorliegenden Erfindung.
Figur 3 zeigt eine schematische Darstellung einer Leiterplattenanordnung mit einer Stromschiene und mehreren elektrischen Anschlussbereichen gemäß einer beispielhaften Ausführungsform der vorliegenden Erfindung.
Figur 4 zeigt eine schematische Darstellung einer Leiterplattenanordnung mit einer Stromschiene, die zwei Steckabschnitte und entsprechende Einsteckpins zur Befestigung in elektrischen Anschlussbereichen aufweist gemäß einer beispielhaften Ausführungsform der vorliegenden Erfindung.
Figur 5 zeigt eine schematische Darstellung einer Leiterplattenanordnung mit mehreren Stromschienen und elektrischen Anschlussbereichen gemäß einer beispielhaften Ausführungsform der vorliegenden Erfindung.
Figur 6 zeigt eine schematische Darstellung einer Leiterplattenanordnung mit mehreren Stromschienen und elektrischen Anschlussbereichen gemäß einer beispielhaften Ausführungsform der vorliegenden Erfindung.
Figur 7 zeigt eine schematische Darstellung einer Leiterplattenanordnung mit vertikal einpressbaren Stromschienen gemäß einer beispielhaften Ausführungsform der vorliegenden Erfindung.
Figur 8 zeigt eine schematische Darstellung einer Leiterplattenanordnung mit vertikal einpressbaren Stromschienen gemäß einer beispielhaften Ausführungsform der vorliegenden Erfindung.
Figur 9 eine schematische Darstellung einer Leiterplattenanordnung mit vertikal einpressbaren Stromschienen gemäß einer beispielhaften Ausführungsform der vorliegenden Erfindung.
Figur 10 zeigt eine schematische Darstellung eines Anschlusselements, das an eine Stromschiene angeklemmt ist gemäß einer beispielhaften Ausführungsform der vorliegenden Erfindung.
Figur 11 zeigt eine schematische Darstellung einer Leiterplattenanordnung mit vertikal einpressbaren Stromschienen gemäß einer beispielhaften Ausführungsform der vorliegenden Erfindung.
Figur 12 zeigt eine schematische Darstellung einer Leiterplattenanordnung mit einer vertikal angeordneten Stromschiene zwischen zwei Leiterplatten gemäß einer beispielhaften Ausführungsform der vorliegenden Erfindung.

### Detaillierte Beschreibung von exemplarischen Ausführungsformen

Gleiche oder ähnliche Komponenten in unterschiedlichen Figuren sind mit gleichen Bezugsziffern versehen. Die Darstellungen in den Figuren sind schematisch.

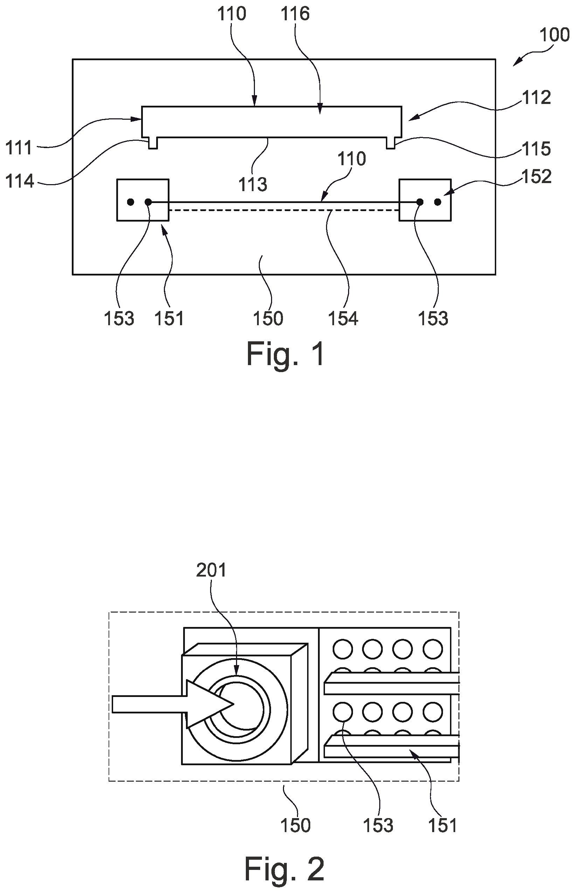

**Fig. 1** zeigt eine Leiterplattenanordnung 100 Leiterplattenanordnung mit einer Stromschiene 110 und zwei elektrischen Anschlussbereichen 151, 152 gemäß einer beispielhaften Ausführungsform der vorliegenden Erfindung. In Fig. 1 ist eine Draufsicht auf die Stromschiene 110 und die Leiterplatte 150 dargestellt. Zur besseren Darstellung der Stromschiene 110 ist ferner eine umgeklappte Seitendarstellung der Stromschienen 110 gezeigt, in welcher die Einsteckpins 114, 115 dargestellt sind.

Die Leiterplattenanordnung 100 weist eine Leiterplatte 150, auf welcher zumindest ein erster elektrischer Anschlussbereich 151 ausgebildet ist, und eine Stromschienenanordnung mit einer ersten Stromschiene 110 zum Übertragen eines elektrischen Stroms auf. Die erste Stromschiene 110 weist zwei gegenüberliegende Hauptflächen auf, die an deren Umfang durch Schmalseiten 113 verbunden sind, aufweist. Die erste Stromschiene 110 weist einen ersten Steckabschnitt 111 und einen beabstandeten zweiten Steckabschnitt 112 auf, welche an einer oder an entsprechenden Schmalseiten 113 der ersten Stromschiene 110 ausgebildet sind, wobei der erste Steckabschnitt 111 zumindest einen ersten Einsteckpin 114 ausbildet und in dem ersten elektrischen Anschlussbereich 151 zumindest eine korrespondierende Einsteckbohrung 153 zur nicht lösbaren Befestigung des ersten Einsteckpins 114 vorgesehen ist. Der zweite Steckabschnitt 112 bildet zumindest einen zweiten Einsteckpin 115 aus, wobei eine korrespondierende zweite Einsteckbohrung 153 eines zweiten elektrischen Anschlussbereichs zur nicht lösbaren Befestigung des zweiten Einsteckpins 115 vorgesehen ist.

Die Leiterplatte 150 selbst ist aus einem Material gefertigt, das sowohl elektrische Isolation als auch mechanische Stabilität bietet. Sie dient als Träger für die elektrischen Komponenten und ermöglicht die Integration verschiedener elektrischer Schaltungen und Verbindungen.

Zwischen dem ersten elektrischen Anschlussbereich 151 und dem zweiten elektrischen Anschlussbereich 152 ist ein elektrischer Verbindungsbereich 353 auf der Leiterplatte 150 ausgebildet, der den ersten elektrischen Anschlussbereich 151 und den zweiten elektrischen Anschlussbereich 152 elektrisch verbindet. Der elektrische Verbindungsbereich 353 umfasst eine Leiterbahn 154, die auf der Oberfläche und/oder in der Leiterplatte 150 ausgebildet ist.

Die erste Stromschiene 110 überbrückt mit einen Zwischenbereich 116 zwischen dem ersten elektrischen Anschlussbereich 151 und dem zweiten elektrischen Anschlussbereich 152. Der Zwischenbereich 116 weist eine größere Querschnittsfläche auf, die insbesondere mehr als 4-fach, vorzugsweise mehr als 10-fach größer ist als die elektrisch leitende Querschnittsfläche der Leiterbahn 154 der Leiterplatte 150. Diese größere Querschnittsfläche dient der Reduktion des elektrischen Widerstands und der Verbesserung der Wärmeableitung.

Die Einsteckpins 114, 115 sowie die Einsteckbohrungen 153 sind so ausgebildet, dass die Einsteckpins zur nicht lösbaren Verbindung in die Einsteckbohrungen eingepresst werden können. Dies ermöglicht eine stabile und dauerhafte elektrische Verbindung zwischen der Stromschiene 110 und den Anschlussbereichen 151 und 152 der Leiterplatte 150.

**Fig. 2** zeigt eine detaillierte Ansicht einer Leiterplattenanordnung, die wesentliche Komponenten und deren Interaktion veranschaulicht. Die Leiterplatte 150 weist einen elektrischen Anschlussbereich 151 auf.

Der Anschlussbereich 151 ist mit Einsteckbohrungen 153 versehen, die eine nicht lösbare Befestigung von Einsteckpins ermöglichen. Diese Einsteckbohrungen 153 sind dimensioniert, um eine sichere und stabile Verbindung mit den Einsteckpins 114, 115 zu gewährleisten. Die Einsteckbohrungen 153 sind so konzipiert, dass sie die Einsteckpins der Stromschienen 110 aufnehmen können und mittels einer Pressverbindung unlösbar fixieren, wodurch eine zuverlässige elektrische Verbindung hergestellt wird.

Neben den Einsteckbohrungen 153 ist ein Kopplungselement 201 zu sehen, das als Steckerbuchse fungiert. Diese Steckerbuchse 201 ist speziell dafür ausgelegt, externe Strom- und/oder Signalelemente zu koppeln. Sie bietet eine Schnittstelle für die Verbindung mit externen Geräten und ermöglicht somit eine Erweiterung der Funktionalität der Leiterplatte 150. Die Steckerbuchse 201 ist robust und kann mechanischen Belastungen standhalten, die bei der Verbindung mit externen Komponenten auftreten können.

Die in Fig. 2 dargestellten Komponenten sind Teil eines modularen Systems, das eine hohe Flexibilität und Anpassungsfähigkeit bietet. Die modulare Bauweise der Stromschienen 110 ermöglicht es, verschiedene Leiterbahnzüge flexibel zu kombinieren, wodurch die Notwendigkeit entfällt, für jeden Kunden individuelle Stromschienen-Geometrien zu entwickeln.

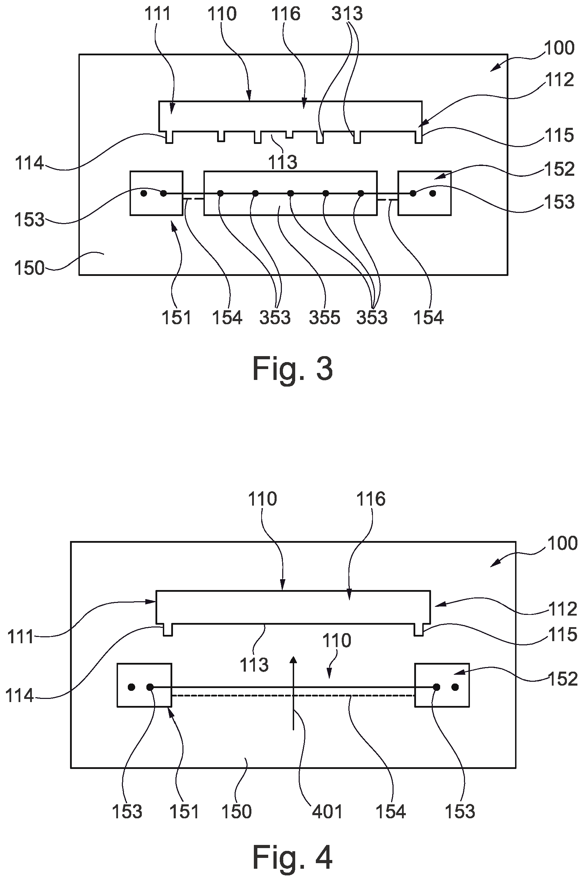

**Fig. 3** zeigt eine Leiterplattenanordnung 100 mit einer Leiterplatte 150 und einer Stromschiene 110. In Fig. 3 ist eine Draufsicht auf die Stromschiene 110 und die Leiterplatte 150 dargestellt. Zur besseren Darstellung der Stromschiene 110 ist ferner eine umgeklappte Seitendarstellung der Stromschienen 110 gezeigt, in welcher die Einsteckpins 114, 115 dargestellt sind.

Die Stromschiene 110 weist zwei gegenüberliegende Hauptflächen auf, die durch Schmalseiten 113 verbunden sind. Die Stromschiene 110 umfasst einen ersten Steckabschnitt 111 und einen beabstandeten zweiten Steckabschnitt 112, die jeweils an den Schmalseiten 113 ausgebildet sind.

Der erste Steckabschnitt 111 bildet mindestens einen ersten Einsteckpin 114 aus, der in eine korrespondierende Einsteckbohrung 153 in einem ersten elektrischen Anschlussbereich 151 der Leiterplatte 150 zur nicht lösbaren Befestigung eingepresst wird. Der zweite Steckabschnitt 112 bildet mindestens einen zweiten Einsteckpin 115 aus, der in eine korrespondierende Einsteckbohrung 153 in einem zweiten elektrischen Anschlussbereich 152 der Leiterplatte 150 zur nicht lösbaren Befestigung eingepresst wird.

Zwischen dem ersten elektrischen Anschlussbereich 151 und dem zweiten elektrischen Anschlussbereich 152 ist ein elektrischer Verbindungsbereich 353 auf der Leiterplatte 150 ausgebildet, der die beiden Anschlussbereiche 151, 152 zusammen mit Leiterbahnen 154 elektrisch verbindet. Der Verbindungsbereich 353 weist Einsteckbohrungen 153 auf, in die Verbindungspins 313 der Stromschiene 110 zur nicht lösbaren Verbindung eingepresst werden können. Die Leiterplatte 150 ist zudem mit Leiterbahnen 154 versehen, die den elektrischen Verbindungsbereich 353 bilden und die elektrischen Anschlussbereiche 151 und 152 miteinander koppeln.

Die Stromschiene 110 überbrückt mit einem Zwischenbereich 116 zwischen dem ersten elektrischen Anschlussbereich 151 und dem zweiten elektrischen Anschlussbereich 152. Der Zwischenbereich 116 weist eine größere Querschnittsfläche auf, die insbesondere mehr als 4-fach, vorzugsweise mehr als 10-fach größer ist als die elektrisch leitende Querschnittsfläche der Leiterbahn 154 der Leiterplatte 150. Dies dient der Reduktion des elektrischen Widerstands und der Verbesserung der Wärmeableitung.

Die Stromschiene 110 kann zusätzliche Kühlstrukturen, wie Kühlrippen, auf der Oberfläche aufweisen, um die passive Kühlwirkung zu erhöhen. Alternativ kann der Zwischenbereich 116 einen Kühlkanal zur Aufnahme eines Kühlmediums enthalten.

Die Leiterplattenanordnung 100 ermöglicht eine modulare und kosteneffiziente Lösung zur Verstärkung der Leiterplatte und zur gezielten Unterstützung von Hotspots. Durch die vertikal einpressbaren Stromschienen wird eine hohe Modularität erreicht, die eine Standardisierung und flexible Kombination mit verschiedenen Leiterbahnzügen ermöglicht. Dies führt zu einer erheblichen Verbesserung der Wärmeableitung und einer Reduktion der Stromdichte in der Leiterplatte, was zu Kosteneinsparungen und einer effizienteren Fertigung beiträgt.

**Fig. 4** zeigt eine Leiterplattenanordnung 100, die eine Leiterplatte 150 und eine Stromschienenanordnung mit einer ersten Stromschiene 110 umfasst. In Fig. 4 ist eine Draufsicht auf die Stromschiene 110 und die Leiterplatte 150 dargestellt. Zur besseren Darstellung der Stromschiene 110 ist ferner eine umgeklappte Seitendarstellung der Stromschienen 110 gezeigt, in welcher die Einsteckpins 114, 115 dargestellt sind.

Die Leiterplatte 150 weist zumindest einen ersten elektrischen Anschlussbereich 151 und einen zweiten elektrischen Anschlussbereich 152 auf. Die erste Stromschiene 110 ist zum Übertragen eines elektrischen Stroms vorgesehen und weist zwei gegenüberliegende Hauptflächen auf, die durch Schmalseiten 113 verbunden sind.

Die erste Stromschiene 110 besitzt einen ersten Steckabschnitt 111 und einen beabstandeten zweiten Steckabschnitt 112, welche an den Schmalseiten 113 der Stromschiene ausgebildet sind. Der erste Steckabschnitt 111 bildet zumindest einen ersten Einsteckpin 114 aus, welcher zur nicht lösbaren Befestigung in einer korrespondierenden Einsteckbohrung 153 des ersten elektrischen Anschlussbereichs 151 vorgesehen ist. Der zweite Steckabschnitt 112 bildet zumindest einen zweiten Einsteckpin 115 aus, welcher zur nicht lösbaren Befestigung in einer korrespondierenden Einsteckbohrung 153 des zweiten elektrischen Anschlussbereichs 152 vorgesehen ist.

Zwischen dem ersten elektrischen Anschlussbereich 151 und dem zweiten elektrischen Anschlussbereich 152 ist eine Leiterbahn 154 auf der Leiterplatte 150 ausgebildet, welcher den ersten elektrischen Anschlussbereich 151 und den zweiten elektrischen Anschlussbereich 152 miteinander elektrisch verbindet. Die Leiterbahn 154 ist auf der Oberfläche und/oder in der Leiterplatte 150 ausgebildet. Die erste Stromschiene 110 weist zwischen dem ersten Steckabschnitt 111 und dem zweiten Steckabschnitt 112 einen Zwischenbereich 116 auf, der eine größere Querschnittsfläche als die elektrisch leitende Querschnittsfläche der Leiterbahn 154 der Leiterplatte 150 aufweist. Der Zwischenbereich 116 kann zur Erhöhung der passiven Kühlwirkung Kühlstrukturen, insbesondere Kühlrippen, auf der Oberfläche aufweisen. Zusätzlich kann der Zwischenbereich 116 einen Kühlkanal aufweisen, welcher zur Aufnahme eines Kühlmediums ausgebildet ist.

In dem Zwischenbereich 116 kann die Leiterplatte 150 eine weitere Leiterbahn 401 (z.B. als Signalpfad) auf der Oberfläche und/oder in der Leiterplatte 150 ausbilden, welche die Stromschiene 110 passiert. Die Einsteckpins 114, 115 sind derart ausgebildet, dass sie zur nicht lösbaren Verbindung in die Einsteckbohrungen 153 einpressbar sind.

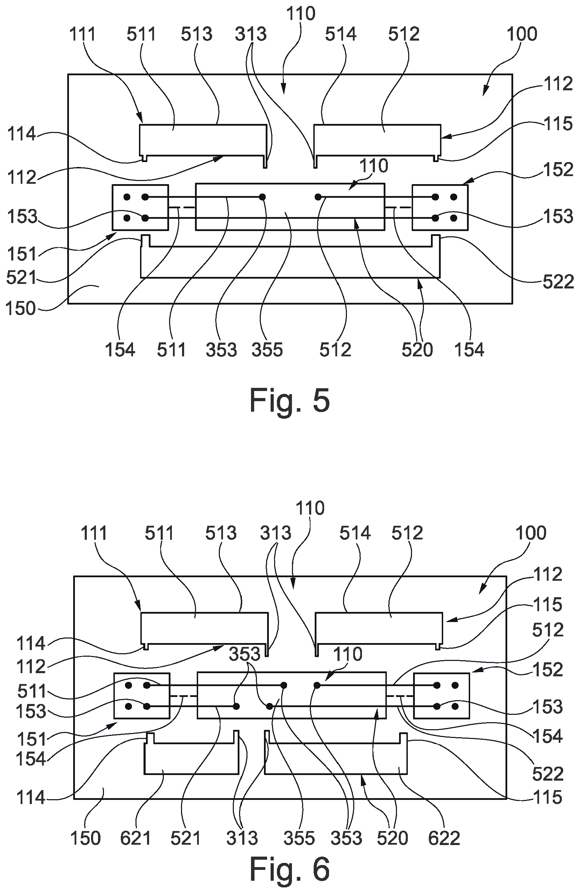

**Fig. 5** zeigt eine detaillierte Darstellung einer Leiterplattenanordnung 100, die eine Stromschienenanordnung umfasst. In Fig. 5 ist eine Draufsicht auf die Stromschiene 110, die Stromschiene 520 und die Leiterplatte 150 dargestellt. Zur besseren Darstellung der Stromschiene 110 und der Stromschiene 520 und sind ferner eine umgeklappte Seitendarstellungen der Stromschienen 110, 520 gezeigt, in welcher die Einsteckpins 114, 115 und Verbindungspins 313 dargestellt sind.

Die Leiterplatte 150 ist mit mehreren elektrischen Anschlussbereichen ausgestattet, darunter der erste Anschlussbereich 151 und der zweite Anschlussbereich 152. Die Stromschienenanordnung besteht aus einer ersten Stromschiene 110 und einer zweiten Stromschiene 520, die beide zum Übertragen von elektrischem Strom dienen.

Die erste Stromschiene 110 ist in zwei Teilschienen 511, 512 unterteilt. Die erste Teilschiene 511 weist einen ersten Steckabschnitt 111 auf, der mit einem ersten Einsteckpin 114 versehen ist. Der Einsteckpin 114 ist zur nicht lösbaren Befestigung in einer korrespondierenden Einsteckbohrung 153 des ersten elektrischen Anschlussbereichs 151 der Leiterplatte 150 ausgebildet. Die zweite Teilschiene 512 ist mit einem zweiten Steckabschnitt 112 ausgestattet, der einen zweiten Einsteckpin 115 aufweist, welcher zur nicht lösbaren Befestigung in einer korrespondierenden Einsteckbohrung 153 des zweiten elektrischen Anschlussbereichs 152 vorgesehen ist.

Ein Verbindungsbereich 355 der Leiterplatte 150 ist durch eine Leiterbahn 154 und/oder ein Anschlussterminal gekennzeichnet, die den ersten elektrischen Anschlussbereich 151 mit dem zweiten elektrischen Anschlussbereich 152 elektrisch koppeln. Der Anschlussterminal weist Einsteckbohrungen 353 auf, welche Verbindungspins 313 der ersten Teilschiene 151 und der zweiten Teilschiene 152 aufnehmen, sodass ein Stromfluss zwischen den ersten Teilschienen 151 und zweiten Teilschienen 152 via dem Anschlussterminal bzw. Anschlussterminal ermöglichen. Die Verbindungspins 313 sind in die Einsteckbohrungen 153 des elektrischen Verbindungsbereichs 355 der Leiterplatte 150 einpressbar.

Insbesondere wird die Flexibilität der Stromschienen Anordnung dargestellt. Während die zweite Stromschiene 520 einstückig die Anschlussbereich 151, 152 verbindet, kann die erste Stromschiene 110 geteilt in die erste Teilschiene 511 und in die zweite Teilschiene 512 bereitgestellt werden. Die Anordnung der Stromschienen 110 und 520 ermöglicht eine effiziente Übertragung elektrischer Ströme zwischen den verschiedenen Anschlussbereichen der Leiterplatte 150. Die zweite Stromschiene 520 verläuft parallel zu der ersten Stromschiene 110. Die parallele Anordnung der Stromschienen bietet die Möglichkeit, komplexe Leiterbahnzüge der Leiterplatte 150 einfach und effizient nachzubilden, und somit die Stromdichte in den nachgebildeten Leiterbahnenzügen zu reduzieren. Die modulare Bauweise der Stromschienen 110, 520 erhöht die Flexibilität und Anpassungsfähigkeit der Leiterplattenanordnung, indem sie die Möglichkeit bietet, unterschiedliche Leiterbahnzüge mit den Stromschienen zu kombinieren.

**Fig. 6** zeigt eine detaillierte Darstellung einer Leiterplattenanordnung 100, die eine Vielzahl von Komponenten und deren Verbindungen veranschaulicht. In Fig. 6 ist eine Draufsicht auf die Stromschiene 110, die Stromschiene 520 und die Leiterplatte 150 dargestellt. Zur besseren Darstellung der Stromschiene 110 und der Stromschiene 520 sind ferner eine umgeklappte Seitendarstellungen der Stromschienen 110, 520 gezeigt, in welcher die Einsteckpins 114, 115 und Verbindungspins 313 dargestellt sind.

Der erste elektrische Anschlussbereich 151 und der zweite elektrische Anschlussbereich 152 sind auf der Leiterplatte 150 angeordnet und durch Einsteckbohrungen 153 gekennzeichnet, die zur Aufnahme von Einsteckpins 114, 115 dienen.

Die Stromschienenanordnung umfasst eine erste Stromschiene 110 und eine zweite Stromschiene 520, die parallel verlaufen und beide zur Übertragung elektrischen Stroms ausgelegt sind. Die erste Stromschiene 110 weist eine erste Teilschiene 511 und eine zweite Teilschiene 512 auf. Diese Teilschienen sind mit Steckabschnitten 111 und 112 ausgestattet, die jeweils Einsteckpins 114 und 115 ausbilden. Diese Einsteckpins 114, 115 sind so konzipiert, dass sie in die korrespondierenden Einsteckbohrungen 153 der elektrischen Anschlussbereiche 151 und 152 eingepresst werden können, wodurch eine nicht lösbare Verbindung entsteht.

Die zweite Stromschiene 520 ist ebenfalls segmentiert und besteht aus einer dritten Teilschiene 621 und einer vierten Teilschiene 622. Diese Teilschienen 621, 622 weisen Steckabschnitte 521 und 522 auf, die mit Einsteckpins 114, 115 ausgestattet sind, die ebenfalls in die Einsteckbohrungen 153 der Anschlussbereiche 151, 152 eingepresst werden können. Die parallele Anordnung der Stromschienen 110 und 520 ermöglicht eine effiziente Stromübertragung und die Möglichkeit, verschiedene Leiterbahnzüge flexibel zu kombinieren.

Zwischen den elektrischen Anschlussbereichen 151 und 152 ist ein elektrischer Verbindungsbereich 353 auf der Leiterplatte 150 ausgebildet. Dieser Bereich enthält Leiterbahnen 154, die die elektrische Verbindung zwischen den Anschlussbereichen gewährleisten und beispielsweise einen Anschlussterminal mit Einsteckbohrungen 353. Die Verbindungspins 313 der Stromschienen sind an einem ersten Verbindungabschnitt 513 der ersten Teilschiene 511 und an einem zweiten Verbindungabschnitt 514 der zweiten Teilschiene 512 angeordnet, so dass sie in die Einsteckbohrungen 353 des Verbindungsbereichs 355 eingepresst werden können, wodurch eine stabile und dauerhafte Verbindung entsteht.

Die Teilschienen 511, 512 der ersten Stromschiene 110 sowie die Teilschienen 621, 622 der zweiten Stromschiene 520 verlaufen parallel und sind beabstandet zueinander angeordnet. Die Erstreckungslänge der ersten Teilschiene 511 unterscheidet sich von der Erstreckungslänge der dritten Teilschiene 621. Zudem unterscheidet sich die Erstreckungslänge der zweiten Teilschiene 512 von der Erstreckungslänge der vierten Teilschiene 622.

Entsprechend kann durch die Ausgestaltung der unterschiedlichen Erstreckungslängen der Teilschienen 511, 512, 621, 622 umgesetzt werden, dass die Trennfugen zwischen den ersten und zweiten Teilschiene 511, 512 der ersten Stromschiene 110 und den vierten und fünften Teilschiene 621, 622 der zweiten Stromschiene 520 an unterschiedlichen Stellen sind bzw. nicht an derselben Stelle entlang der Gesamtlänge der ersten Teilschiene 110 und der zweiten Teilschiene 520.

Zusätzlich ist ein Zwischenbereich 355 zwischen den Stromschienen 110 und 520 sichtbar, der eine größere Querschnittsfläche aufweist, um die Kühlwirkung zu erhöhen und den Widerstand der Leiterbahnen zu reduzieren. Diese Konstruktion unterstützt die Wärmeableitung und trägt zur Reduzierung der Stromdichte in der Leiterplatte bei, was zu einer verbesserten Leistung und Effizienz der Leiterplattenanordnung führt.

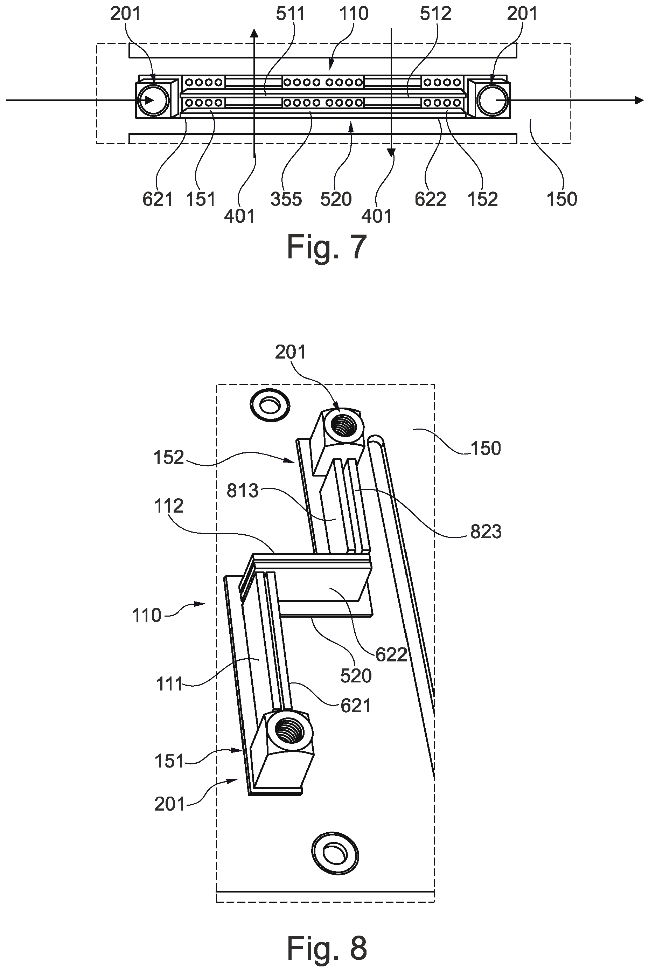

**Fig.** 7 zeigt eine Leiterplattenanordnung 100, die eine Leiterplatte 150 umfasst, auf welcher ein erster elektrischer Anschlussbereich 151 ausgebildet ist und ein zweiter Anschlussbereich 152 angeordnet ist zwischen dem ersten Anschlussbereich 151 und dem zweiten Anschlussbereich 152 ist ein Verbindungsbereiche 355 dargestellt.

Die Leiterplattenanordnung 100 umfasst eine Stromschienenanordnung mit einer ersten Stromschiene 110 und einer zweiten Stromschiene 520 zum Übertragen eines elektrischen Stroms. Die Ausführungsformen in Fig. 7 entspricht der Ausführungsform aus Fig. 6, wobei die Erstreckungslänge der Teilschienen 511, 522, 621, 622 gleich sind. Die Stromschienen 110 und 520 sind parallel zueinander angeordnet.

Die erste Teilschiene 511 und die zweite Teilschiene 512 sind beabstandet zueinander angeordnet und erstrecken sich entlang einer ersten Erstreckungsrichtung bzw. einer zweiten Erstreckungsrichtung. Die dritte Teilschiene 621 und die vierte Teilschiene 622 sind ebenfalls beabstandet zueinander angeordnet und erstrecken sich entlang einer dritten Erstreckungsrichtung bzw. einer vierten Erstreckungsrichtung.

Zwischen dem ersten elektrischen Anschlussbereich 151 und dem zweiten elektrischen Anschlussbereich 152 ist ein elektrischer Verbindungsbereich 355 auf der Leiterplatte 150 ausgebildet, welcher den ersten elektrischen Anschlussbereich 151 und den zweiten elektrischen Anschlussbereich 152 miteinander elektrisch verbindet. Der elektrische Verbindungsbereich 355 umfasst weitere Leiterbahnen (Signalbrücken) 401 auf der Oberfläche und/oder in der Leiterplatte 150. Die weitere Leiterbahnen 401 werden insbesondere durch die jeweiligen Teilschienen 511, 522, 621, 622 überbrückt.

Die Verbindungspins 313 der Stromschienen 110, 520 sind zur nicht lösbaren Verbindung mit korrespondierenden Einsteckbohrungen 153 im Verbindungsbereich 355 ausgebildet. Die Einsteckpins 114, 115 der ersten Stromschiene 110 sowie die Einsteckpins 114, 115 der zweiten Stromschiene 520 sind ebenfalls zur nicht lösbaren Verbindung in die Einsteckbohrungen 153 einpressbar.

Die Leiterplatte 150 weist zudem Kopplungselemente 201, insbesondere Steckerbuchsen oder Gewindebuchsen, zum Koppeln mit externen Strom- und/oder Signalelementen auf.

**Fig. 8** zeigt eine detaillierte Ansicht einer Leiterplattenanordnung 100, die mit vertikal einpressbaren Stromschienen 110, 520 ausgestattet ist. Die Leiterplatte 150 ist mit mehreren elektrischen Anschlussbereichen versehen. Die Stromschienenanordnung besteht aus einer ersten Stromschiene 110 und einer zweiten Stromschiene 520, die jeweils drei Teilschienen 511, 512, 813, 621, 622, 823 und Einsteckpins aufweisen.

Die erste Stromschiene 110, 520 ist so konzipiert, dass sie mit ihren Einsteckpins 114, 115 vertikal in die Leiterplatte 150 eingepresst werden können, um eine stabile und nicht lösbare Verbindung zu gewährleisten.

Die zweite Stromschiene 520 verläuft parallel zur ersten Stromschiene 110 angeordnet, was eine kompakte und effiziente Struktur ermöglicht.

An einem ersten Anschlussbereich 151 ist eine erste Steckerbuchse 201 vorgesehen und an einem zweiten , gegenüberliegenden Anschlussbereich 152 ist eine weitere Steckerbuchse 201 vorgesehen.

Insbesondere besteht die Stromschiene 110 und die weitere Stromschiene 520 aus jeweils 3 Segmenten bzw. Teilschienen 511, 512, 813, 621, 622, 823. Die zweite Teilschiene 512 ist dabei insbesondere orthogonal zu der ersten Teilschiene 511 und der weiteren Teilschiene 813 der ersten Stromschiene 110 angeordnet. Entsprechend ist die vierte Teilschiene 622 orthogonal zu der dritten Teilschiene 621 und der weiteren Teilschiene 823 angeordnet. Mit der dargestellten Ausführungsform, kann beispielsweise aufgrund der segmentierten Stromschienen 110, 520 ein komplexer, nichtlinearer Verlauf entlang der Leiterplatte 150 bereitgestellt werden. Ferner kann aufgrund der Segmentierung der Stromschienen 110, 520 ein Baukastensystem geschaffen werden, mit dem eine Vielzahl unterschiedlicher nichtlinearer Verläufe der Stromschienen 110, 520 entlang einer Leiterplatte erzielt werden kann.

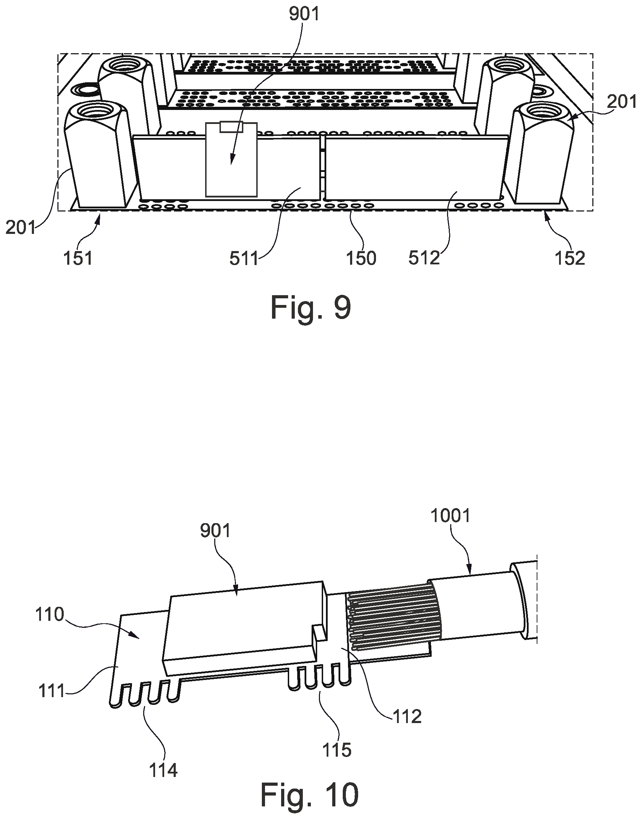

**Fig. 9** zeigt eine Leiterplattenanordnung 100, die eine Leiterplatte 150 umfasst, auf welcher zumindest ein erster elektrischer Anschlussbereich 151 und ein zweiter elektrischer Anschlussbereich 152 ausgebildet sind. Die Leiterplatte 150 ist mit einer Stromschiene 110 versehen, die eine erste Teilschiene 511 und eine zweite Teilschiene 512 umfasst. Die erste Teilschiene 511 ist mit dem ersten elektrischen Anschlussbereich 151 verbunden, während die zweite Stromschiene 512 mit dem zweiten elektrischen Anschlussbereich 152 verbunden ist. Beide Stromschienen sind vertikal einpressbar und bieten eine nicht lösbare Befestigung durch Einsteckpins, die in korrespondierende Einsteckbohrungen der Anschlussbereiche eingepresst werden.

Des Weiteren zeigt Fig. 9 ein Anschlusselement 901, welches zur Ausbildung einer elektrischen Verbindung einer externen elektrischen Vorrichtung mit der ersten Stromschiene 511 dient. Das Anschlusselement 901 ist an die Stromschiene 110 angeklemmt und ermöglicht eine effiziente Stromübertragung.

Die Leiterplatte 150 ist zudem mit mehreren Kopplungselementen 201 ausgestattet, die als Steckerbuchsen dienen und eine Verbindung mit externen Strom- und/oder Signalelementen ermöglichen. Diese Kopplungselemente sind strategisch an den elektrischen Anschlussbereichen 151 und 152 positioniert, um eine optimale elektrische Kopplung zu gewährleisten.

**Fig. 10** zeigt eine Stromschienenanordnung, die für die elektrische Verbindung zwischen einer Leiterplatte 150 und einem externen Stromleiter 1001 konzipiert ist. Die Stromschiene 110 ist mit einem ersten Steckabschnitt 111 und einem zweiten Steckabschnitt 112 ausgestattet. Diese Steckabschnitte 111, 112 sind so gestaltet, dass sie eine nicht lösbare Verbindung mit korrespondierenden Einsteckbohrungen 153 auf einer Leiterplatte 150 ermöglichen.

Der erste Steckabschnitt 111 ist an einer Schmalseite 113 der Stromschiene 110 ausgebildet und verfügt über Einsteckpins 114, die in die entsprechenden Einsteckbohrungen 153 der Leiterplatte 150 eingepresst werden können. Der zweite Steckabschnitt 112 ist beabstandet zum ersten Steckabschnitt 111 angeordnet und weist ebenfalls Einsteckpins 115 auf, die zur Befestigung in weiteren Einsteckbohrungen 153 vorgesehen sind.

Auf der Stromschiene 110 ist ein Anschlusselement 901 montiert, dass eine elektrische Verbindung zu einer externen Vorrichtung herstellt. Dieses Anschlusselement kann eine Klemmeinrichtung umfassen, die es ermöglicht, das Anschlusselement 901 sicher an der Stromschiene 110 zu befestigen. Das Anschlusselement 901 kann auch als Mess-Shunt fungieren, um die Stromstärke zu überwachen, die durch die Stromschiene fließt.

Der externe Stromleiter 1001 ist mit dem Anschlusselement 901 verbunden und stellt die Verbindung zwischen der Stromschiene 110 und einer externen elektrischen Quelle oder Last her. Der Stromleiter 1001 ist typischerweise ein drahtgebundener Leiter, der eine sichere und zuverlässige Stromübertragung gewährleistet.

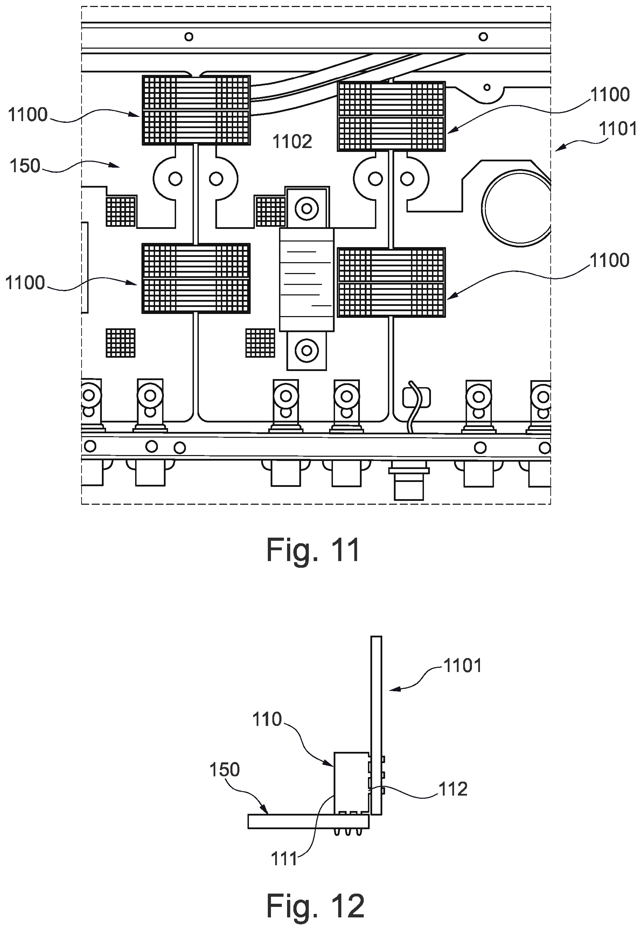

**Fig. 11** zeigt eine Leiterplattenanordnung, die mehrere einpressbare Stromschienenanordnung 1100 mit vertikal einpressbare ein Stromschienen umfasst. Die Stromschienenanordnungen 1100 sind auf einer Hauptleiterplatte 150 und zwei weiteren Leiterplatten 1101 und 1102 montiert. Die Hauptleiterplatte 150 und die weiteren Leiterplatten 1101 und 1102 sind innerhalb einer Leiterplattenebene angeordnet

Die Leiterplattenanordnung in Fig. 11 zeigt, dass die Stromschienenanordnungen 1100 in verschiedenen Bereichen der Leiterplatten 150, 1101, 1102 montiert sind, um eine optimale Verteilung des elektrischen Stroms und eine effiziente Kühlung zu gewährleisten.

Die Leiterplattenanordnung in Fig. 11 zeigt auch die Möglichkeit, die Stromschienenanordnungen 1100 als Signalbrücken zu verwenden, um einen effizienten Signalaustausch bzw. Stromaustausch zwischen den Leiterplatten 150, 1101, 1102 zu ermöglichen. Die Stromschienen der Stromschienenanordnungen 1100 sind dabei derart ausgebildet, dass erste Steckabschnitt 111 in Einsteckbohrungen einer Leiterplatte 150, 1101, 1102 eingepresst ist und der zweite Steckabschnitt 112 in Einsteckbohrungen auf einer benachbarten Leiterplatte 150, 1101, 1102 eingepresst ist. Neben dem Stromaustausch und Signalaustausch der entsprechenden Leiterplatten 150, 1101, 1102 werden diese aufgrund der robusten Stromschienen der Stromschienenanordnungen 1100 zusätzlich mechanisch verstärkt.

**Fig. 12** zeigt eine Leiterplattenanordnung 100 mit einer ersten Leiterplatte 150 und einer weiteren Leiterplatte 1101. Die erste Stromschiene 110 ist zwischen den beiden Leiterplatten 150 und 1101 angeordnet. Die Stromschiene 110 weist einen ersten Steckabschnitt 111 und einen beabstandeten zweiten Steckabschnitt 112 auf. Der erste Steckabschnitt 111 ist in die erste Leiterplatte 150 eingepresst, während der zweite Steckabschnitt 112 in die weitere Leiterplatte 1101 eingepresst ist.

Der erste Steckabschnitt 111 und der zweite Steckabschnitt 112 sind an entsprechenden angrenzenden Schmalseiten der Stromschiene 110 ausgebildet und weisen Einsteckpins 114, 115 auf, die in korrespondierende Einsteckbohrungen 153 der jeweiligen Leiterplatten 150, 1101 eingepresst werden.

Die Leiterplatte 150 und die weitere Leiterplatte 1101 sind nebeneinander angeordnet, wobei die erste Stromschiene 110 an dem ersten elektrischen Anschlussbereich 151 der Leiterplatte 150 und dem zweiten elektrischen Anschlussbereich 152 der weiteren Leiterplatte 1101 gekoppelt ist. Die Leiterplatte 150 und die weitere Leiterplatte 1101 können in einem Winkel zueinander angeordnet werden, wobei der Winkel insbesondere 90° beträgt.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden ist, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

**Bezugszeichenliste:**

| | | | |
|---|---|---|---|
| 100 | Leiterplattenanordnung | 511 | erste Teilschiene |
| 110 | erste Stromschiene | 512 | zweite Teilschiene |
| 111 | erster Steckabschnitt | 513 | erster Verbindungsabschnitt |
| 112 | zweiter Steckabschnitt | 514 | zweiter Verbindungsabschnitt |
| 113 | Schmalseite | | |
| 114 | erster Einsteckpin | 520 | zweite Stromschiene |
| 115 | zweiter Einsteckpin | 521 | dritter Steckabschnitt |
| 116 | Zwischenbereich | 522 | vierter Steckabschnitt |
| 150 | Leiterplatte | 621 | dritte Teilschiene |
| 151 | erster Anschlussbereich | 622 | vierte Teilschiene |
| 152 | zweiter Anschlussbereich | | |
| 153 | Einsteckbohrung | 813 | weiterer Teilschiene |
| 154 | Leiterbahn | 823 | weiterer Teilschiene |
| 201 | Steckerbuchse | 901 | Anschlusselement |
| 313 | Verbindungspin | 100 1 | Stromleiter |
| 353 | Einsteckbohrung | | |
| 355 | Verbindungsbereich | 1100 | Stromschienenanordnung |
| | | 110 1 | weitere Leiterplatte |
| 401 | weitere Leiterbahn | 1102 | weitere Leiterplatte |

## Patentansprüche

1. Leiterplattenanordnung (100), aufweisend
eine Leiterplatte (150), auf welcher zumindest ein erster elektrischer Anschlussbereich (151) ausgebildet ist,
eine Stromschienenanordnung mit einer ersten Stromschiene (110) zum Übertragen eines elektrischen Stroms, wobei die erste Stromschiene (110) zwei gegenüberliegende Hauptflächen aufweist, die an deren Umfang durch Schmalseiten (113) verbunden sind,
wobei die erste Stromschiene (110) einen ersten Steckabschnitt (111) und einen beabstandeten zweiten Steckabschnitt (112) aufweist, welche an einer oder an entsprechenden Schmalseiten (113) der ersten Stromschiene (110) ausgebildet sind,
wobei der erste Steckabschnitt (111) zumindest einen ersten Einsteckpin (114) ausbildet und wobei in dem ersten elektrischen Anschlussbereich (151) zumindest eine korrespondierende Einsteckbohrung (153) zur nicht lösbaren Befestigung des ersten Einsteckpins (114) vorgesehen ist,
wobei der zweite Steckabschnitt (112) zumindest einen zweiten Einsteckpin (115) ausbildet und wobei eine korrespondierende zweite Einsteckbohrung (153) eines zweiten elektrischen Anschlussbereichs zur nicht lösbaren Befestigung des zweiten Einsteckpins (115) vorgesehen ist.

2. Leiterplattenanordnung (100) gemäß Anspruch 1, mit zumindest einem der folgenden Merkmale:
wobei die Stromschiene (110) derart an einer Oberfläche der Leiterplatte (15) befestigt ist, dass die Hauptflächen orthogonal zu der Oberfläche der Leiterplatte sind;
wobei der erste Anschlussbereich (151) mit einem elektronischem Bauelement der Leiterplatte (150) elektrisch gekoppelt ist;
wobei der erste Anschlussbereich (151) ein Kopplungselement, insbesondere eine Steckerbuchse (201) oder eine Gewindebuchse, zum Koppeln mit externen Strom- und/oder Signalelementen aufweist;
wobei der zweite elektrische Anschlussbereich (152) auf der Leiterplatte (150) ausgebildet ist, und wobei der zweite elektrische Anschlussbereich (152) insbesondere beabstandet zu dem ersten elektrischen Anschlussbereich (151) ausgebildet ist;
wobei zwischen dem ersten elektrischen Anschlussbereich (151) und dem zweiten elektrischen Anschlussbereich (152) ein elektrischen Verbindungsbereich (353) auf der Leiterplatte (150) ausgebildet ist, welche den ersten elektrischen Anschlussbereich (151) und den zweiten elektrischen Anschlussbereich (152) miteinander elektrisch verbindet;
wobei die Verbindungspins (313) und/oder die Einsteckpins (114, 115) einerseits und die Einsteckbohrungen (153) andererseits derart ausgebildet sind, dass die Verbindungspins (313) und/oder die Einsteckpins (114, 115) zur nicht lösbaren Verbindung in die Einsteckbohrungen (153) einpressbar sind.

3. Leiterplattenanordnung (100) gemäß Anspruch 2,
wobei der elektrische Verbindungsbereich (353) eine Leiterbahn (154) auf der Oberfläche und/oder in der Leiterplatte (150) ausgebildet, welche den ersten elektrischen Anschlussbereich (151) mit dem zweiten elektrischen Anschlussbereich (152) elektrisch koppelt.

4. Leiterplattenanordnung (100) gemäß Anspruch 2 oder 3,
wobei die erste Stromschiene (110) zwischen dem ersten Steckabschnitt (111) und dem zweiten Steckabschnitt (112) an einer Schmalseite (113) Verbindungspins (313) aufweist,
wobei der elektrische Verbindungsbereich (353) Einsteckbohrungen (153) aufweist,
wobei die Verbindungspins (313) zur nicht lösbaren Verbindung mit dem korrespondierende Einsteckbohrungen (153) im Verbindungsbereich (353) ausgebildet sind.

5. Leiterplattenanordnung (100) gemäß einem der Ansprüche 1 bis 4, wobei der zweite elektrische Anschlussbereich (152) und der erste elektrische Anschlussbereich (151) mittels der ersten Stromschiene (110) elektrisch verbunden sind und die erste Stromschiene (110) einen Zwischenbereich (116) zwischen dem ersten elektrischen Anschlussbereich (151) und dem zweiten elektrischen Anschlussbereich (152) überbrückt.

6. Leiterplattenanordnung (100) gemäß Anspruch 5,
wobei der Zwischenbereich (116) ein größere Querschnittsfläche, insbesondere einen mehr als 4-fach, insbesondere mehr als 10-fach größere Querschnittsfläche als eine elektrisch leitende Querschnittsfläche des Verbindungsbereichs (353) der Leiterplatte (150) aufweist, wobei der Zwischenbereich (116) auf der Oberfläche vorzugsweise Kühlstrukturen, insbesondere Kühlrippen, zur Erhöhung der passiven Kühlwirkung aufweist, wobei der Zwischenbereich (116) vorzugsweise einen Kühlkanal aufweist, welcher zur Aufnahme eines Kühlmediums ausgebildet ist,
wobei in dem Zwischenbereich (116) die Leiterplatte (150) vorzugsweise eine weitere Leiterbahn (401) auf der Oberfläche und/oder in der Leiterplatte (150) ausgebildet, welche die Stromschiene (110) passiert.

7. Leiterplattenanordnung (100) gemäß einem der Ansprüche 1 bis 6, wobei die Stromschienenanordnung eine zweite Stromschiene (520) zum Übertragen eines elektrischen Stroms aufweist,
wobei die zweite Stromschiene (520) einen dritten Steckabschnitt (521) und einen beabstandeten vierten Steckabschnitt (522) aufweist, welche an einer oder an entsprechenden Schmalseiten (113) der zweiten Stromschiene (520) ausgebildet sind,
wobei der dritte Steckabschnitt (521) zumindest einen dritten Einsteckpin ausbildet und wobei in dem ersten elektrischen Anschlussbereich (151) zumindest eine korrespondierende Einsteckbohrung (153) zur nicht lösbaren Befestigung des dritten Einsteckpins vorgesehen ist,
wobei der vierte Steckabschnitt (522) der zweiten Stromschiene (520) zumindest einen vierten Einsteckpin ausbildet und wobei in einer korrespondierende vierten Einsteckbohrung (153) des zweiten elektrischen Anschlussbereichs zur nicht lösbaren Befestigung des vierten Einsteckpins vorgesehen ist, wobei die zweite Stromschiene (520) vorzugsweise parallel zu der ersten Stromschiene (110) angeordnet ist, wobei zumindest die erste Stromschiene (110) vorzugsweise eine erste Teilschiene (511) und eine zweite Teilschiene (512) aufweist, wobei die erste Teilschiene (511) den ersten Steckabschnitt aufweist und die zweite Teilschiene (512) den zweiten Steckabschnitt aufweist, wobei die erste Teilschiene (511) vorzugsweise einen ersten Verbindungsabschnitt (513) mit ersten Verbindungspins (313) aufweist, die zur nicht lösbaren Verbindung mit korrespondierende Einsteckbohrungen (153) im Verbindungsbereich (353) ausgebildet sind, wobei die zweite Teilschiene (512) vorzugsweise einen zweiten Verbindungsabschnitt (514) mit zweiten Verbindungspins (313) aufweist, die zur nicht lösbaren Verbindung mit korrespondierende Einsteckbohrungen (153) im Verbindungsbereich (353) ausgebildet sind,
wobei die erste Teilschiene (511) und die zweite Teilschiene (512) vorzugsweise beabstandet zueinander angeordnet sind.

8. Leiterplattenanordnung (100) gemäß Anspruch 7,
wobei sich die erste Teilschiene (511) von dem ersten Einsteckabschnitt mit einer ersten Erstreckungslänge entlang einer ersten Erstreckungsrichtung zu dem ersten Verbindungsabschnitt (513) erstreckt und die zweite Teilschiene (512) von dem zweiten Einsteckabschnitt mit einer zweiten Erstreckungslänge entlang einer zweiten Erstreckungsrichtung zu dem zweiten Verbindungsabschnitt (514) erstreckt, wobei die erste Erstreckungslänge und die zweite Erstreckungslänge vorzugsweise unterschiedlich lang sind, wobei vorzugsweise die erste Erstreckungsrichtung und die zweite Erstreckungsrichtung parallel zueinander sind, oder wobei die erste Erstreckungsrichtung und die zweite Erstreckungsrichtung einen Winkel zueinander aufweisen, wobei der Winkel insbesondere 90° beträgt.

9. Leiterplattenanordnung (100) gemäß einem der Ansprüche 7 und 8, wobei zumindest die zweite Stromschiene (520) eine dritte Teilschiene (621) und eine vierte Teilschiene (622) aufweist, wobei die dritte Teilschiene (621) den dritten Steckabschnitt aufweist und die vierte Teilschiene (622) den vierten Steckabschnitt aufweist,
wobei die dritte Teilschiene (621) einen dritten Verbindungsabschnitt mit dritten Verbindungspins (313) aufweist, die zur nicht lösbaren Verbindung mit korrespondierende Einsteckbohrungen (153) im Verbindungsbereich (353) ausgebildet sind,
wobei die vierte Teilschiene (622) einen vierten Verbindungsabschnitt mit vierten Verbindungspins (313) aufweist, die zur nicht lösbaren Verbindung mit korrespondierende Einsteckbohrungen (153) im zweiten Anschlussbereich (152) ausgebildet sind, wobei sich die dritte Teilschiene (621) vorzugsweise von dem dritten Einsteckabschnitt mit einer dritten Erstreckungslänge entlang einer dritten Erstreckungsrichtung zu dem dritten Verbindungsabschnitt erstreckt und die vierte Teilschiene (622) vorzugsweise von dem vierten Einsteckabschnitt mit einer vierten Erstreckungslänge entlang einer vierten Erstreckungsrichtung zu dem vierten Verbindungsabschnitt, wobei sich zumindest eine der ersten und zweiten Erstreckungslängen vorzugsweise von zumindest einer der dritten und vierten Erstreckungslängen unterscheidet.

10. Leiterplattenanordnung (100) gemäß einem der Ansprüche 1 bis 9, ferner aufweisend
ein Anschlusselement (901), welches zum Ausbilden einer elektrischen Verbindung einer externen elektrischen Vorrichtung mit zumindest der ersten Stromschiene (110) ausgebildet ist.

11. Leiterplattenanordnung (100) gemäß Anspruch 10, mit zumindest einem der folgenden Merkmale:
wobei das Anschlusselement (901) eine Klemmeinrichtung aufweist, mittels welcher das Anschlusselement (901) an zumindest die erste Stromschiene (110) angeklemmt werden kann;
wobei das Anschlusselement (901) einen Mess-Shunt ausbildet;
wobei das Anschlusselement (901) mit einem drahtgebunden Stromleiter (1001) gekoppelt ist, sodass mittels des Anschlusselements (901) eine elektrische Verbindung zwischen dem Stromleiter (1001) und der ersten Stromschiene (110) bereitstellbar ist.

12. Leiterplattenanordnung (100) gemäß einem der Ansprüche 1 bis 3, ferner aufweisend
eine weitere Leiterplatte (1101, 1102),
wobei der zweite elektrische Anschlussbereich (152) auf der weiteren Leiterplatte (1101, 1102) ausgebildet ist.

13. Leiterplattenanordnung (100) gemäß Anspruch 12, mit zumindest einem der folgenden Merkmale:
wobei der erste Steckabschnitt (111) und der zweite Steckabschnitt (112) auf derselben Schmalseite (113) der ersten Stromschiene (110) angeordnet sind, und wobei die Leiterplatte (150) und die weitere Leiterplatte (1101, 1102) nebeneinander angeordnet sind und die erste Stromschiene (110) an dem ersten elektrischen Anschlussbereich (151) der Leiterplatte (150) und dem zweiten elektrischen Anschlussbereich (152) gekoppelt ist;
wobei die erste Stromschiene (110) eine erste Schmalseite (113) und eine, an die erste Schmalseite (113) angrenzende zweite Schmalseite aufweist, und
wobei die erste Schmalseite (113) und die zweite Schmalseite einen Winkel zueinander aufweisen, wobei der Winkel insbesondere 90° beträgt, und wobei der erste Steckabschnitt (111) an der ersten Schmalseite (113) und der zweite Steckabschnitt (112) an der zweiten Schmalseite ausgebildet ist, sodass die Leiterplatte (150) und die weitere Leiterplatte (1101, 1102) in einem Winkel zueinander anordbar sind;
wobei die erste Stromschiene (110) eine erste Schmalseite (113) und eine, bezüglich der Hauptflächen gegenüberliegende zweite Schmalseite aufweist, und wobei die erste Schmalseite (113) und die zweite Schmalseite parallel und beabstandet zueinander ausgebildet sind, und wobei der erste Steckabschnitt (111) an der ersten Schmalseite (113) und der zweite Steckabschnitt (112) an der zweiten Schmalseite ausgebildet ist, sodass die Leiterplatte (150) und die weitere Leiterplatte (1101, 1102) parallel und beabstandet zueinander anordbar.

14. Stromschienenanordnung für eine Leiterplattenanordnung (100) gemäß einem der Ansprüche 1 bis 13, die Stromschienenanordnung aufweisend
eine erste Stromschiene (110) zum Übertragen eines elektrischen Stroms, wobei die erste Stromschiene (110) zwei gegenüberliegende Hauptflächen aufweist, die an deren Umfang durch Schmalseiten (113) verbunden sind,
wobei die erste Stromschiene (110) einen ersten Steckabschnitt (111) und einen beabstandeten zweiten Steckabschnitt (112) aufweist, welche an einer oder an entsprechenden Schmalseiten (113) der ersten Stromschiene (110) ausgebildet sind,
wobei der erste Steckabschnitt (111) zumindest einen ersten Einsteckpin (114) ausbildet, welcher zur nicht lösbaren Befestigung in einer korrespondierenden Einsteckbohrung (153) eines ersten elektrischen Anschlussbereichs einer Leiterplatte (150) ausgebildet ist,
wobei der zweite Steckabschnitt (112) zumindest einen zweiten Einsteckpin (115) ausbildet, welcher zur nicht lösbaren Befestigung in einer korrespondierenden Einsteckbohrung (153) eines zweiten elektrischen Anschlussbereichs ausgebildet ist.

15. Verfahren zum Herstellen einer Leiterplattenanordnung (100) gemäß einem der Ansprüche 1 bis 13.
